(19) Europäisches Patentamt
European Patent Office
Office européen des brevets

(11) **EP 2 359 605 B1**

(12) **EUROPÄISCHE PATENTSCHRIFT**

(45) Veröffentlichungstag und Bekanntmachung des Hinweises auf die Patenterteilung:
**02.01.2013 Patentblatt 2013/01**

(51) Int Cl.:
*H01S 5/022* *(2006.01)*    *H04N 9/31* *(2006.01)*
*G02F 1/35* *(2006.01)*    *H01S 5/00* *(2006.01)*

(21) Anmeldenummer: **09767929.4**

(22) Anmeldetag: **19.10.2009**

(86) Internationale Anmeldenummer:
**PCT/DE2009/001448**

(87) Internationale Veröffentlichungsnummer:
**WO 2010/069282 (24.06.2010 Gazette 2010/25)**

(54) **LEUCHTMITTEL UND PROJEKTOR MIT MINDESTENS EINEM SOLCHEN LEUCHTMITTEL**

LUMINOUS MEANS AND PROJECTOR COMPRISING AT LEAST ONE LUMINOUS MEANS OF THIS TYPE

MOYEN LUMINEUX ET PROJECTEUR COMPRENANT AU MOINS UN MOYEN LUMINEUX DE CE TYPE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **18.12.2008 DE 102008063634**

(43) Veröffentlichungstag der Anmeldung:
**24.08.2011 Patentblatt 2011/34**

(73) Patentinhaber: **OSRAM Opto Semiconductors GmbH**
**93055 Regensburg (DE)**

(72) Erfinder:
• **LELL, Alfred**
**93142 Maxhütte-Haidhof (DE)**
• **TAUTZ, Sönke**
**93105 Tegernheim (DE)**
• **STRAUSS, Uwe**
**93077 Bad Abbach (DE)**
• **BEHRINGER, Martin Rudolf**
**93049 Regensburg (DE)**
• **BRÜNINGHOFF, Stefanie**
**93197 Zeitlarn (DE)**
• **DINI, Dimitri**
**80686 München (DE)**
• **EISERT, Dominik**
**93049 Regensburg (DE)**
• **EICHLER, Christoph**
**93105 Tegernheim (DE)**

(74) Vertreter: **Epping - Hermann - Fischer Patentanwaltsgesellschaft mbH Ridlerstrasse 55 80339 München (DE)**

(56) Entgegenhaltungen:
WO-A2-2006/129211    US-A1- 2005 265 411
US-A1- 2006 139 926

EP 2 359 605 B1

**Beschreibung**

Es wird ein Leuchtmittel angegeben. Darüber hinaus wird ein Projektor mit mindestens einem solchen Leuchtmittel angegeben.

In der Druckschrift US 2006/139926 A1 ist ein Licht emittierendes Bauteil angegeben.

Die Druckschrift WO 2006/129211 A2 betrifft eine spektral breitbandig emittierende Laserlichtquelle mit reduziertem Speckle-Muster.

Ein optisch Dioden-gepumpter Festkörperlaser findet sich in der Druckschrift US 2005/0265411 A1.

Eine zu lösende Aufgabe besteht darin, ein Leuchtmittel mit einer hohen Leuchtdichte anzugeben. Eine weitere zu lösende Aufgabe besteht darin, einen Projektor mit zumindest einem solchen Leuchtmittel anzugeben.

Gemäß zumindest einer Ausführungsform des Leuchtmittels umfasst dieses wenigstens einen optoelektronischen Halbleiterchip. Der Halbleiterchip ist dazu ausgestaltet, elektromagnetische Strahlung im ultravioletten oder sichtbaren Spektralbereich zu erzeugen. Bei dem Halbleiterchip kann es sich um eine Leuchtdiode oder einen Halbleiterlaser handeln.

Gemäß zumindest einer Ausführungsform des Leuchtmittels weist dieses mindestens einen Halbleiterlaser auf, der dazu eingerichtet ist, eine Primärstrahlung mit einer Wellenlänge zwischen einschließlich 360 nm und 485 nm, insbesondere zwischen einschließlich 380 nm und 460 nm, zu emittieren. Mit anderen Worten ist die Primärstrahlung über wenigstens einen Halbleiterlaser erzeugt. Das Leuchtmittel kann insbesondere frei von Leuchtdioden sein, sodass die Primärstrahlung ausschließlich über Halbleiterlaser erzeugt ist.

Gemäß zumindest einer Ausführungsform des Leuchtmittels beinhaltet dieses mindestens ein Konversionsmittel. Das Konversionsmittel ist dem Halbleiterlaser in Strahlrichtung der Primärstrahlung nachgeordnet und dazu eingerichtet, wenigstens einen Teil der Primärstrahlung in eine Sekundärstrahlung zu konvertieren. Die Sekundärstrahlung weist eine von der Primärstrahlung verschiedene, bevorzugt größere Wellenlänge auf.

Gemäß zumindest einer Ausführungsform des Leuchtmittels ist eine vom Leuchtmittel emittierte Strahlung durch die Sekundärstrahlung oder durch eine Mischung aus Sekundärstrahlung und Primärstrahlung gebildet. Handelt es sich bei der vom Leuchtmittel emittierten Strahlung um eine Mischstrahlung, so ist die Strahlung bevorzugt bereits beim Verlassen des Leuchtmittels gemischt. Die vom Leuchtmittel emittierte Strahlung ist insbesondere über einen gesamten Strahlquerschnitt der Strahlung homogen. Mit anderen Worten weicht ein Farbort der vom Leuchtmittel emittierten Strahlung über den gesamten Strahlquerschnitt um höchstens 0,05 Einheiten, insbesondere um höchstens 0,025 Einheiten in der Normfarbtafel von einem Mittelwert, gebildet über den gesamten Strahlquerschnitt, ab.

Gemäß zumindest einer Ausführungsform des Leuchtmittels weist die vom Leuchtmittel emittierte Strahlung eine optische Kohärenzlänge auf, die höchstens 50 $\mu$m beträgt. Bevorzugt beträgt die optische Kohärenzlänge höchstens 10 $\mu$m, insbesondere höchstens 2,5 $\mu$m. Mit anderen Worten handelt es sich bei der vom Leuchtmittel emittierten Strahlung um inkohärente Strahlung, die nicht interferenzfähig ist. Hierdurch sind Effekte wie Speckle-Muster, die bei der Verwendung einer kohärenten Strahlung beispielsweise zu Projektionszwecken auftreten können, vermeidbar.

Dem Einsatz des Konversionsmittels im Leuchtmittel liegt unter anderem folgende Idee zugrunde: Die Primärstrahlung des Leuchtmittels ist von einem Halbleiterlaser erzeugt, der damit eine vergleichsweise große Kohärenzlänge aufweist und interferenzfähig ist. Durch die Verwendung des Konversionsmittels, das insbesondere eine Vielzahl von voneinander unabhängigen Farbzentren oder Leuchtpunkten beinhaltet, wird eine inkohärente Sekundärstrahlung erzeugt. Die Sekundärstrahlung ist insbesondere deshalb inkohärent, da die Vielzahl von beispielsweise Farbzentren entkoppelt voneinander die Primärstrahlung absorbieren und zeitlich versetzt und nicht miteinander korreliert die konvertierte Strahlung, die Sekundärstrahlung, emittieren. Auch eine räumlich definierte Beziehung zwischen einzelnen beispielsweise Farbzentren ist im Regelfall nicht gegeben. Daher weist die von den einzelnen beispielsweise Farbzentren emittierte Sekundärstrahlung keine feste oder definierte Phasenbeziehung zu von benachbarten Farbzentren emittierter Sekundärstrahlung auf. Zudem weist die Sekundärstrahlung, im Vergleich zu Primärstrahlung, eine vergleichsweise große spektrale Breite auf. Hierdurch ist die Kohärenzlänge ebenfalls reduziert.

Gemäß zumindest einer Ausführungsform des Leuchtmittels ist die optische Kohärenzlänge kleiner als oder gleich dem Quotienten aus dem Quadrat einer mittleren Wellenlänge der Strahlung und einer spektralen Bandbreite der vom Leuchtmittel emittierten Strahlung, multipliziert mit einem konstanten Faktor:

$$L \le k\ \lambda_0^2/\Delta\lambda$$

L bezeichnet hierbei die optische Kohärenzlänge der vom Leuchtmittel emittierten Strahlung, $\lambda_0$ die mittlere Wellenlänge der vom Leuchtmittel emittierten Strahlung und $\Delta\lambda$ deren spektrale Breite. Insbesondere beträgt die optische Kohärenzlänge höchstens 90 %, insbesondere höchstens 75 % des über obige Formel sich ergebenden Werts.

Über die oben angegebene Formel kann die optische Kohärenzlänge einer Strahlung, abhängig von der Bandbreite und der mittleren Wellenlänge der Strahlung, abgeschätzt werden. Der Faktor k, der eine reelle Zahl in der Größenordnung von 1 ist, ist abhängig von einer Einhüllenden eines Spektrums der Strahlung. Die vom Leuchtmittel emittierte Strahlung kann mit anderen Worten eine kürzere Kohärenzlänge aufweisen, als sich für eine Strahlung mit einer entsprechenden spektralen Breite gemäß obiger Formel ergibt. Die optische Kohärenzlänge kann also insbesondere kürzer als für eine spektral breitbandige Lichtquelle sein, die beispielsweise auf einem Laser basiert.

Ist die vom Leuchtmittel emittierte Strahlung eine Mischstrahlung aus Sekundärstrahlung und Primärstrahlung, so weist die Strahlung auch in diesem Fall eine geringe Kohärenzlänge auf, da über ein Mischen von Primärstrahlung und Sekundärstrahlung die Phasenbeziehung und somit die Interferenzfähigkeit zerstört ist.

Die optische Kohärenzlänge kann beispielsweise über ein Interferometer bestimmt werden. Das Interferometer weist zum Beispiel zwei Interferometerarme auf, die einen variierbaren Längenunterschied zueinander aufzeigen. Wird die Strahlung über die beiden Arme gelenkt und anschließend überlagert, so zeigt sich in Abhängigkeit vom Längenunterschied der Arme ein Interferenzmuster. Diejenige Länge des Armlängenunterschieds, ab der sich kein Interferenzmuster mehr zeigt, ist dann die optische Kohärenzlänge.

In mindestens einer Ausführungsform des Leuchtmittels beinhaltet dieses mindestens einen Halbleiterlaser, der dazu eingerichtet ist, eine Primärstrahlung mit einer Wellenlänge zwischen einschließlich 360 nm und 485 nm zu emittieren. Weiterhin umfasst das Leuchtmittel mindestens ein Konversionsmittel, das dem Halbleiterlaser nachgeordnet und dazu eingerichtet ist, wenigstens einen Teil der Primärstrahlung in eine Sekundärstrahlung mit einer von der Primärstrahlung verschiedenen, größeren Wellenlänge zu konvertieren. Die vom Leuchtmittel emittierte Strahlung zeigt hierbei eine optische Kohärenzlänge auf, die höchstens 50 $\mu$m beträgt.

Über den Halbleiterlaser, der kohärente Strahlung emittiert, ist die Primärstrahlung effizient formbar, insbesondere fokussierbar. Hierdurch sind hohe Leistungsdichten der Primärstrahlung im Konversionsmittel erzielbar. Damit einhergehend kann auch eine hohe Leuchtdichte der Sekundärstrahlung und eine nahezu punktförmige Abstrahlung der Sekundärstrahlung erreicht werden. Durch die kleine optische Kohärenzlänge lassen sich zum Beispiel Speckle-Muster etwa bei einer Projektion der vom Leuchtmittel emittierten Strahlung vermeiden.

Gemäß zumindest einer Ausführungsform des Leuchtmittels ist das Konversionsmittel frei oder überwiegend frei von einem organischen Material. Zum Beispiel beinhaltet das Konversionsmittel ein Matrixmaterial aus einem Glas oder einer gesinterten Keramik. In das Matrixmaterial sind beispielsweise Leuchtstoffpartikel oder -pigmente eingebettet. Organische Materialien sind gegenüber photochemischer Beschädigung, die bei hohen Leuchtdichten insbesondere der Primärstrahlung auftreten kann, oft nur bedingt widerstandsfähig. Umfasst das Konversionsmittel kein organisches Material, so kann eine hohe Leuchtdichte der Sekundärstrahlung erzielt werden.

Gemäß zumindest einer Ausführungsform des Leuchtmittels umfasst das mindestens eine Konversionsmittel wenigstens einen Cer- oder Europium-dotierten Leuchtstoff.

Gemäß zumindest einer Ausführungsform des Leuchtmittels weist das mindestens eine Konversionsmittel eine Konzentration von Farbzentren oder Leuchtpunkten auf, die mindestens $10^7/\mu m^3$ beträgt, bevorzugt mindestens $5*10^7/\mu m^3$, insbesondere mindestens $10^8/\mu m^3$. Die Farbzentren oder Leuchtpunkte sind bevorzugt statistisch im Konversionsmittel verteilt, sodass keine feste beziehungsweise regelmäßige, gitterähnliche räumliche Beziehung zwischen einander benachbarten Farbzentren oder Leuchtpunkten besteht, und emittieren die Sekundärstrahlung unabhängig voneinander. Durch eine solche hohe Dichte der unabhängig voneinander emittierenden Farbzentren oder Leuchtpunkte ist eine besonders kleine optische Kohärenzlänge der Sekundärstrahlung realisierbar.

Gemäß zumindest einer Ausführungsform des Leuchtmittels sind durch die Primärstrahlung im Konversionsmittel mindestens so viele Farbzentren oder Leuchtpunkte angeregt, wie dem Produkt aus der Vakuumlichtgeschwindigkeit mit einer Abklingzeit des Konversionsmittels, geteilt durch die Kohärenzlänge, entspricht:

$$N \geq (c\ T)/L$$

L bezeichnet hierbei die optische Kohärenzlänge, c die Vakuumlichtgeschwindigkeit, T die insbesondere exponentielle Abklingzeit des Konversionsmittels und N die Anzahl durch die Primärstrahlung angeregter Farbzentren oder Leuchtpunkte. Bevorzugt ist N größer oder gleich dem Zehnfachen der rechten Seite obiger Formel, insbesondere größer oder gleich dem Fünfzigfachen.

Mit anderen Worten werden umso mehr Farbzentren oder Leuchtpunkte angeregt, je größer die Abklingzeit des Konversionsmittels ist. Beispielsweise ist N größer als $10^6$, insbesondere größer als $10^8$. Die große Anzahl angeregter Farbzentren oder Leuchtpunkte, bezogen auf die Abklingzeit, kann eine kleine Kohärenzlänge erlauben.

Gemäß zumindest einer Ausführungsform des Leuchtmittels beträgt eine Leuchtdichte der Sekundärstrahlung beim Austritt aus dem Konversionsmittel wenigstens stellenweise mindestens 1 kW/cm². Bevorzugt übersteigt die Leuchtdichte 10 kW/cm², besonders bevorzugt 100 kW/cm², insbesondere 1000 kW/cm².

Gemäß zumindest einer Ausführungsform des Leuchtmittels umfasst dieses einen thermisch leitfähigen, ersten Träger. Das mindestens eine Konversionsmittel ist zumindest mittelbar, insbesondere unmittelbar auf dem ersten Träger angebracht. Bevorzugt steht das Material des Konversionsmittels in direktem Kontakt zu einem Material des ersten Trägers. Hierdurch ist eine effiziente thermische Ankopplung und ein effizientes Abführen von Wärme aus dem Konversionsmittel über den ersten Träger gewährleistbar.

Gemäß zumindest einer Ausführungsform des Leuchtmittels ist der erste Träger mindestens für einen Teil der Sekundärstrahlung transparent oder reflektierend gestaltet. Transparent bedeutet hierbei, dass mindestens 90 %, bevorzugt mindestens 95 % der Sekundärstrahlung den ersten Träger durchlaufen, ohne eine Streuung oder Absorption zu erfahren. Reflektierend bedeutet, dass mindestens 90 %, bevorzugt mindestens 95 % der auf den ersten Träger treffenden Sekundärstrahlung an diesem reflektiert werden.

Gemäß zumindest einer Ausführungsform des Leuchtmittels ist der erste Träger für die Primärstrahlung transparent oder undurchlässig gestaltet. Transparent bedeutet, dass mindestens 90 %, bevorzugt mindestens 95 % der Primärstrahlung den ersten Träger durchdringen, ohne absorbiert oder gestreut zu werden. Undurchlässig bedeutet, dass höchstens 1 ‰ der Primärstrahlung den ersten Träger durchdringen kann.

Gemäß zumindest einer Ausführungsform des Leuchtmittels umfasst dieses zumindest eine Kollimatoroptik. Diese Kollimatoroptik ist dem Konversionsmittel in Strahlrichtung der Primär- und/oder der Sekundärstrahlung nachgeordnet. Über die Kollimatoroptik kann ein Divergenzwinkel der durch die Konversion erzeugten Sekundärstrahlung vermindert und/oder eingestellt werden. Die Kollimatoroptik kann ein Achromat sein.

Gemäß zumindest einer Ausführungsform des Leuchtmittels beträgt der Divergenzwinkel der Sekundärstrahlung nach Durchgang durch die Kollimatoroptik zumindest stellenweise höchstens 10°, bevorzugt höchstens 5°, insbesondere höchstens 1,5°. Eine geringe Divergenz der Sekundärstrahlung erleichtert die Strahlführung der Sekundärstrahlung und deren Strahlformung, zum Beispiel in nachgeordneten optischen Elementen.

Gemäß zumindest einer Ausführungsform des Leuchtmittels ist die mindestens eine Kollimatoroptik dazu eingerichtet, aus der Sekundärstrahlung ein paralleles Strahlbündel zu formen. Parallel kann hierbei bedeuten, dass der Divergenzwinkel des Strahlbündels höchstens 1°, bevorzugt höchstens 0,5° beträgt. Dies ist dadurch ermöglicht, dass die Sekundärstrahlung mit einer hohen Leuchtdichte in einem kleinen Raumbereich erzeugt ist.

Gemäß zumindest einer Ausführungsform des Leuchtmittels weist dieses zumindest einen von der Primärstrahlung bestrahlten Leuchtfleck des Konversionsmittels auf. Der Leuchtfleck ist hierbei insbesondere diejenige, bevorzugt zusammenhängende Fläche des Konversionsmittels, über den die Primärstrahlung in das Konversionsmittel eindringt.

Gemäß zumindest einer Ausführungsform des Leuchtmittels ist das Konversionsmittel an einer Lichteintrittsfläche, insbesondere im Bereich des Leuchtflecks und/oder an einer Lichtaustrittsfläche aufgeraut. Hierdurch verbessert sich eine Lichtein- und Lichtauskopplung aus beziehungsweise in das Konversionsmittel. Auch erfolgt an der Lichtein- und an der Lichtaustrittsfläche eine Lichtstreuung, über die die Kohärenzlänge der Strahlung reduziert sein kann.

Gemäß zumindest einer Ausführungsform des Leuchtmittels weist der mindestens eine Leuchtfleck eine Fläche von höchstens 0,5 mm$^2$ auf, bevorzugt von höchstens 0,1 mm$^2$. Zum Beispiel liegt die Fläche des Leuchtflecks im Intervall zwischen einschließlich 10 $\mu$m$^2$ und 10000 $\mu$m$^2$, insbesondere zwischen einschließlich 100 $\mu$m$^2$ und 2000 $\mu$m$^2$. Mit anderen Worten ist die Sekundärstrahlung in einem punktartigen Bereich erzeugt. Ist eine Strahlungseintrittsfläche bezüglich der Primärstrahlung des Konversionsmittels aufgeraut, so ist unter der Fläche des Leuchtflecks diejenige Fläche zu verstehen, die sich aus einer Projektion der real von der Primärstrahlung beleuchteten Fläche auf eine insbesondere fiktive Ebene senkrecht zu einer Strahlachse der Primärstrahlung ergibt.

Gemäß zumindest einer Ausführungsform des Leuchtmittels weist dieses zumindest zwei Halbleiterlaser auf, die denselben Leuchtfleck bestrahlen. Mit anderen Worten bestrahlen die zumindest zwei Halbleiterlaser, im Rahmen der Herstellungs- und Justagegenauigkeiten, dieselbe Stelle des Konversionsmittels. Über die Verwendung zweier Halbleiterlaser zur Beleuchtung desselben Leuchtflecks können besonders hohe Leuchtdichten bezüglich der Sekundärstrahlung realisiert sein. Ist das Konversionsmittel eine Mischung aus zumindest zwei verschiedenen Leuchtstoffen, so können die den Leuchtfleck bestrahlenden Halbleiterlaser unterschiedliche Wellenlängen der Primärstrahlung aufweisen, um eine besonders effiziente Erzeugung der Sekundärstrahlung zu gewährleisten.

Gemäß zumindest einer Ausführungsform des Leuchtmittels weist dieses, neben dem ersten Träger, wenigstens einen zweiten Träger auf. Das Konversionsmittel befindet sich jeweils in mindestens mittelbarem Kontakt zu den Trägern, insbesondere in direktem Kontakt.

Gemäß zumindest einer Ausführungsform des Leuchtmittels befindet sich das Konversionsmittel zwischen dem ersten Träger und dem zweiten Träger. Insbesondere kann das Material des Konversionsmittels in direktem Kontakt jeweils zu den Materialien des ersten und des zweiten Trägers stehen.

Gemäß zumindest einer Ausführungsform des Leuchtmittels durchläuft die Primärstrahlung zumindest einen der Träger. Insbesondere kann die Primärstrahlung sowohl den ersten als auch den zweiten Träger durchlaufen.

Gemäß zumindest einer Ausführungsform des Leuchtmittels ist das Konversionsmittel auf einer Hauptseite des ersten Trägers aufgebracht. Diese Hauptseite ist bezüglich der Sekundärstrahlung reflektierend gestaltet oder mit einer bezüglich der Sekundärstrahlung reflektierend wirkenden Beschichtung versehen, sodass an der Hauptseite mindestens 90 %, insbesondere mindestens 95 % der Sekundärstrahlung reflektiert werden. Ebenso ist die Hauptseite bevorzugt bezüglich der Primärstrahlung reflektierend gestaltet oder mit einer reflektierenden Beschichtung versehen. Mit anderen Worten erfolgt die Konversion nicht durch Transmission durch das Konversionsmittel hindurch, sondern über Reflexion am ersten Träger. Und ein Strahlweg, eine Strahlachse oder eine Hauptstrahlrichtung der Primär- und/ oder Sekundärstrahlung erfährt an der Hauptseite des ersten Trägers eine Richtungsänderung.

Gemäß zumindest einer Ausführungsform des Leuchtmittels umfasst dieses wenigstens drei Halbleiterlaser. Zwei der Halbleiterlaser beleuchten zumindest zwei verschiedene Leuchtflecke des Konversionsmittels. Die vom Leuchtmittel emittierte Strahlung umfasst rotes, grünes und blaues Licht. Beispielsweise werden zwei der Halbleiterlaser dazu eingesetzt, aus blauem oder ultraviolettem Licht der Primärstrahlung über Konversion an verschiedenen Leuchtflecken rotes und grünes Licht zu erzeugen. Das blaue Licht kann ebenfalls über Konversion erzeugt sein oder auch durch die Primärstrahlung eines der drei Halbleiterlaser gebildet sein. Die vom Leuchtmittel emittierte Strahlung ist also beispielsweise eine Mischung aus rotem, grünem und blauem, jeweils insbesondere mittels Konversion erzeugtem Licht oder auch eine Mischung aus etwa rotem und grünem Licht der Sekundärstrahlung und blauem Licht der Primärstrahlung. An den Leuchtflecken, die von den Halbleiterlasern beleuchtet werden, können voneinander verschiedene Konversionsmittel oder Mischungen von Konversionsmitteln eingesetzt werden, so dass zum Beispiel eine der Leuchtflecke nur rote Sekundärstrahlung und ein weiterer der Leuchtflecke nur grüne Sekundärstrahlung emittiert.

Gemäß zumindest einer Ausführungsform des Leuchtmittels sind das rote, grüne und blaue Licht unabhängig voneinander erzeugbar. Dies kann dadurch realisiert sein, dass Leuchtflecke des Konversionsmittels von unterschiedlichen Halbleiterlasern bestrahlt werden und die Halbleiterlaser bezüglich ihrer Intensität in der Zeitdomäne veränderbar einstellbar sind. Es können also zu verschiedenen Zeitpunkten, insbesondere unabhängig voneinander, unterschiedliche Intensitäten eingestellt werden. Ebenso ist es möglich, dass sich zwischen dem mindestens einen Halbleiterlaser und dem Konversionsmittel eine Komponente befindet, die die Intensität der Primärstrahlung modulieren kann.

Gemäß zumindest einer Ausführungsform des Leuchtmittels durchlaufen das rote, grüne und blaue Licht wenigstens einen Teil des Strahlwegs gemeinsam. Mit anderen Worten sind rotes, grünes und blaues Licht parallel zueinander geführt und weisen im Rahmen der Herstellungstoleranzen identische Strahlachsen auf, wenigstens entlang einer Teilstrecke des Strahlwegs. Bevorzugt handelt es sich bei dem roten, grünen und blauen Licht um jeweils parallele Strahlbündel.

Gemäß zumindest einer Ausführungsform des Leuchtmittels umfasst dieses wenigstens einen Modulator, der sich im Strahlweg der Sekundärstrahlung befindet, und der dazu eingerichtet ist, über Transmission oder Reflexion eine Intensität der Sekundärstrahlung einzustellen. Bei dem Modulator kann es sich um eine Flüssigkristalleinheit, um einen Mikrospiegelaktor, englisch Spatial Light Modulator, kurz SLM, handeln. Ebenso ist es möglich, dass der Modulator durch wenigstens eine Pockels-Zelle oder Kerr-Zelle gebildet ist. Wirkt der Modulator transmissiv, so kann also, in Abhängigkeit von der Zeit, die Intensität der den Modulator durchlaufenden Sekundärstrahlung eingestellt werden. Wirkt der Modulator reflektiv, so kann ein Reflexionsgrad oder eine Reflexionsrichtung zeitlich variiert sein.

Gemäß zumindest einer Ausführungsform des Leuchtmittels ist eine Intensität und/oder ein Farbort der vom Leuchtmittel emittierten Strahlung mit einer Frequenz von mindestens 10 MHz, insbesondere von mindestens 25 MHz abstimmbar. Das Abstimmen kann beispielsweise über einen Digital Micro-mirror Device, kurz DMD, erfolgen. Solch hohe Abstimmraten ermöglichen einen Einsatz des Leuchtmittels beispielsweise in einem Projektor, insbesondere in einem so genannten Flying Spot Projector.

Gemäß zumindest einer Ausführungsform des Leuchtmittels ist der erste Träger mechanisch beweglich gelagert und weist wenigstens zwei Bereiche auf, die mit voneinander verschiedenen Konversionsmitteln versehen sind. Wird der Träger verschoben, so bestrahlt die Primärstrahlung beispielsweise unterschiedliche Bereiche und somit verschiedene Konversionsmittel. Insbesondere ist der erste Träger in einer Richtung, speziell ausschließlich in einer Richtung senkrecht zu einer Strahlachse der Primärstrahlung beweglich, so dass durch ein Bewegen des ersten Trägers zum Beispiel keine oder keine wesentliche Änderung eines Strahlwegs der Primärstrahlung und/oder der Sekundärstrahlung erfolgt. Hierdurch ist also der Farbort der Sekundärstrahlung durch ein Positionieren oder Bewegen des ersten Trägers festlegbar.

Gemäß zumindest einer Ausführungsform des Leuchtmittels ist der erste Träger, auf dem das Konversionsmittel aufgebracht ist, mechanisch beweglich gelagert. Ein Bewegen des Trägers, in einer Richtung senkrecht zur Strahlachse der Primärstrahlung, erfolgt wenigstens zeitweise mit einer Geschwindigkeit von mindestens 1 cm/s, insbesondere von mindestens 5 cm/s. Hierdurch ist eine thermische Belastung des Konversionsmittels begrenzbar.

Gemäß zumindest einer Ausführungsform des Leuchtmittels weist der erste und/oder der zweite Träger eine thermische Leitfähigkeit von mindestens 40 W/(m K) auf, bevorzugt von mindestens 120 W/(m K), insbesondere von mindestens 300 W/(m K). Zum Beispiel ist der erste Träger mit Siliziumcarbid, Saphir, Diamant oder einer insbesondere transparenten Keramik wie zum Beispiel AIN gestaltet.

Gemäß zumindest einer Ausführungsform des Leuchtmittels umfasst dieses wenigstens eine Lochblende, die dem Konversionsmittel nachgeordnet ist. Über die Lochblende kann Streustrahlung am Verlassen des Leuchtmittels gehindert werden, sodass die vom Leuchtmittel emittierte Strahlung in einem definierten, kleinen Raumbereich abgestrahlt wird und eine Strahlformung in etwa einem dem Leuchtmittel nachgeordneten optischen Element ermöglicht ist.

Gemäß zumindest einer Ausführungsform des Leuchtmittels weist ein Bereich an der Hauptfläche des ersten Trägers, an dem das Konversionsmittel angebracht ist, einen Durchmesser auf, der höchstens einem Dreifachen eines mittleren Durchmessers des Leuchtflecks entspricht, insbesondere höchstens einem Zweifachen, bevorzugt höchstens einem 1,2-fachen des mittleren Durchmessers des Leuchtflecks.

Gemäß zumindest einer Ausführungsform des Leuchtmittels weist dieses eine Ablenkeinheit und/oder eine Abbildungseinheit auf, die sich in oder an dem Strahlweg befindet. Die Ablenkeinheit kann durch einen Mikrospiegelaktor gebildet sein. Bei der Abbildungseinheit kann es sich um eine Flüssigkristallmaske handeln.

Gemäß zumindest einer Ausführungsform des Leuchtmittels ist das Konversionsmittel vom Halbleiterlaser thermisch entkoppelt. Das heißt, es findet kein oder kein signifikantes thermisches Übersprechen vom Konversionsmittel auf den Halbleiterlaser und umgekehrt statt. Dies ermöglicht ein bezüglich Intensität und Farbort besonders stabiles Betreiben des Leuchtmittels.

Gemäß zumindest einer Ausführungsform des Leuchtmittels umfasst dieses ein oberflächenmontierbares Gehäuse, in dem der mindestens eine Halbleiterlaser montiert ist. Ebenso kann sich das mindestens eine Konversionsmittel teilweise oder vollständig in dem Gehäuse befinden. Das Gehäuse ist zum Beispiel gemäß der Druckschrift US 2007/0091945 A1 gestaltet. Bei dem Gehäuse kann es sich ebenso um ein Gehäuse gemäß der Druckschrift US 2008/0116551 A1 handeln.

Gemäß zumindest einer Ausführungsform des Leuchtmittels ist das Gehäuse als so genanntes Transistor Single Outline Gehäuse, kurz TO-Gehäuse, gestaltet.

Gemäß zumindest einer Ausführungsform des Leuchtmittels liegt das Volumen des gesamten Leuchtmittels im Bereich zwischen einschließlich $0,01$ mm$^3$ und $60$ mm$^3$, insbesondere zwischen einschließlich $0,4$ mm$^3$ und $8$ mm$^3$.

Es wird darüber hinaus ein Projektor angegeben. Der Projektor umfasst zumindest ein Leuchtmittel gemäß einem der vorhergehenden Ansprüche sowie mindestens eine Ablenkeinheit und/oder mindestens eine Abbildungseinheit.

Einige Anwendungsbereiche, in denen hier beschriebene Leuchtmittel Verwendung finden können, sind etwa die Hinterleuchtungen von Displays oder Anzeigeeinrichtungen. Weiterhin können die hier beschriebenen Leuchtmittel auch in Beleuchtungseinrichtungen zu Projektionszwecken, in Scheinwerfern oder Lichtstrahlern oder bei der Allgemeinbeleuchtung eingesetzt werden.

Nachfolgend ist ein hier beschriebenes Leuchtmittel sowie ein hier beschriebener Projektor unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:

Figuren 1 bis 5  schematische Darstellungen von Ausführungsbeispielen von hier beschriebenen Leuchtmitteln mit einem ersten Träger,

Figuren 6 bis 8  schematische Darstellungen von Ausführungsbeispielen von hier beschriebenen Leuchtmitteln mit einem zweiten Träger,

Figur 9  eine schematische Darstellung eines Ausführungsbeispiels eines hier beschriebenen Leuchtmittels mit einem als Optik gestalteten ersten Träger,

Figuren 10 und 11  schematische Darstellungen von Ausführungsbeispielen von hier beschriebenen Leuchtmitteln mit verschiedenen Konversionsmitteln,

Figur 12  eine schematische Darstellung eines Ausführungsbeispiels eines hier beschriebenen Leuchtmittels, bei dem mehrere Halbleiterlaser einen Leuchtfleck bestrahlen,

Figuren 13 bis 15  schematische Darstellungen von weiteren Ausführungsbeispielen von hier beschriebenen Leuchtmitteln,

Figuren 16 und 17  schematische Darstellungen von Ausführungsbeispielen von hier beschriebenen Projektoren,

Figuren 18 und 19  schematische Darstellungen von Ausführungsbeispielen von weiteren hier beschriebenen Leuchtmitteln, und

Figuren 20 bis 29  schematische Darstellungen von Ausführungsbeispielen von hier beschriebenen Leuchtmitteln mit einem Gehäuse.

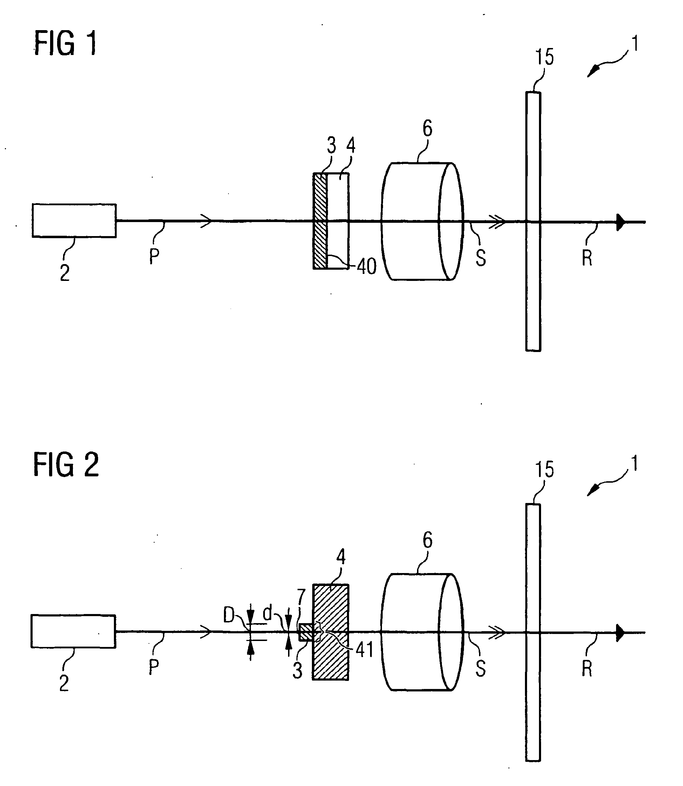

In Figur 1 ist ein Ausführungsbeispiel eines Leuchtmittels 1 illustriert. Ein Halbleiterlaser 2 emittiert eine Primärstrahlung P, symbolisiert durch eine einfach gepfeilte Linie. Die Primärstrahlung P weist eine Wellenlänge zwischen 370 nm und 400 nm auf. Dem Halbleiterlaser 2 in einer Strahlrichtung der Primärstrahlung P nachgeordnet befindet sich ein Konversionsmittel 3, das in einer Schicht an einer Hauptseite 40 eines ersten Trägers 4 aufgebracht ist. Eine Schichtdicke des Konversionsmittels 3, in einer Richtung senkrecht zur Hauptseite 40, liegt zwischen zirka 1 $\mu$m und 1000 $\mu$m, bevorzugt zwischen einschließlich 3 $\mu$m und 300 $\mu$m. Das Konversionsmittel 3 umfasst wenigstens einen Cer- und/oder Europium-dotierten Leuchtstoff.

Durch das Konversionsmittel 3 wird die Primärstrahlung P absorbiert und in eine längerwellige Sekundärstrahlung S konvertiert. Eine Hauptstrahlrichtung der Sekundärstrahlung S ist durch eine zweifach gepfeilte Linie symbolisiert. Die Primärstrahlung P, die eine Laserstrahlung ist, weist im Vergleich zur Sekundärstrahlung S eine sehr große optische Kohärenzlänge auf. Durch den Einsatz des Konversionsmittels 3 mit einer Vielzahl von Farbzentren oder Leuchtpunkten ist die Kohärenzlänge stark verkleinert und störende Effekte, beispielsweise durch Speckle-Muster, können unterbunden werden.

In geringer Distanz in Strahlrichtung nach dem Konversionsmittel 3 ist eine Kollimatoroptik 6 angebracht. Die zur Kollimatoroptik 6 gelangende Sekundärstrahlung S wird in ein näherungsweise paralleles Strahlbündel geformt. Bei der Kollimatoroptik 6 kann es sich um einen so genannten Achromaten handeln.

Optional ist der Kollimatoroptik 6 in Strahlrichtung ein Filter 15 nachgeordnet. Bei dem Filter 15 kann es sich um einen Farbfilter und/oder um einen Polarisationsfilter handeln. Durch den Filter 15 können bestimmte Spektralanteile herausgefiltert werden. Insbesondere kann der Filter 15 bezüglich der Primärstrahlung P undurchlässig gestaltet sein. In diesem Fall ist eine vom Leuchtmittel emittierte Strahlung R, symbolisiert durch eine Linie mit einem ausgefüllten Pfeil, lediglich wenigstens ein Teil der Sekundärstrahlung S.

Beim Ausführungsbeispiel gemäß Figur 2 ist das Konversionsmittel 3 nur in einem kleinen Bereich 41 mit einem Durchmesser D auf der Hauptseite 40 des ersten Trägers 4 aufgebracht. Ein Leuchtfleck 7 mit einem Durchmesser d ist durch diejenige Fläche definiert, die die Primärstrahlung P an einer dem Halbleiterlaser 2 zugewandten Seite des Konversionsmittels 3 bestrahlt. Ein Verhältnis D/d der Durchmesser liegt in der Größenordnung von 1. Der Leuchtfleck 7 weist eine Fläche zwischen einschließlich 10 $\mu$m$^2$ und 10.000 $\mu$m$^2$ auf. Der Leuchtfleck 7 kann etwa mittels eines Siebdruckverfahrens oder auch mittels eines lithografischen Prozesses strukturiert auf dem Träger 4 aufgebracht sein. Um einen derartig kleinen Leuchtfleck 7 über die Primärstrahlung P zu realisieren, kann zwischen dem Halbleiterlaser 2 und dem Konversionsmittel 3 eine in Figur 2 nicht gezeichnete Linse angebracht sein.

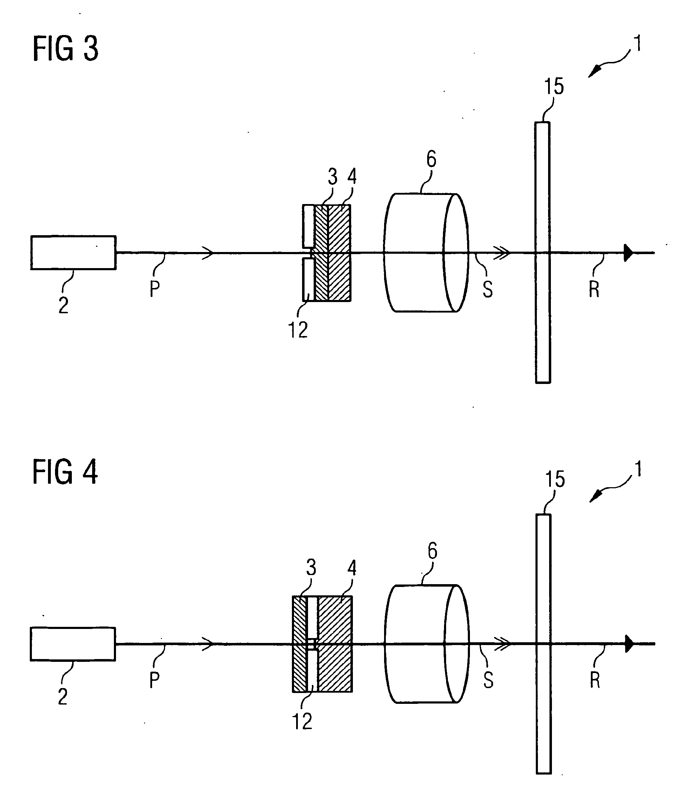

Gemäß Figur 3 umfasst das Leuchtmittel 1 eine Lochblende 12. Die Lochblende 12 ist auf einer dem Halbleiterlaser 2 zugewandten Hauptseite des flächig auf den Träger 4 aufgebrachten Konversionsmittels 3 angeordnet. Beispielsweise ist die Lochblende durch eine Metallisierung mit Gold, Silber, Platin, Palladium, Titan, Chrom oder einem anderen Metall gebildet, das hoch reflektierend bezüglich der Sekundärstrahlung gestaltet sein kann. Ebenso kann die Lochblende 12 mit einer beispielsweise dielektrischen Schichtenfolge in Form eines Bragg-Spiegels gestaltet sein. In diesem Fall weist die Lochblende 12 eine Schichtenfolge von etwa Aluminiumoxid, Siliziumoxid, Siliziumnitrid, Tantaloxid, Titanoxid, Nioboxid und/oder Neodymoxid auf. Die einzelnen Schichten weisen jeweils bevorzugt eine optische Dicke von einem Viertel einer Wellenlänge der Sekundärstrahlung S auf. Auch ist es möglich, dass das Material der Lochblende 12 absorbierend wirkt und zum Beispiel Ruß ist.

Eine Leistung der Sekundärstrahlung S beträgt einige 10 mW bis einige 100 mW, kann aber auch einige W betragen. Zur Abfuhr der durch die Konversion im Konversionsmittel 3 resultierenden Wärme ist der Träger 4 bevorzugt mit einem Material mit einer hohen thermischen Leitfähigkeit gestaltet, zum Beispiel mit Saphir oder Siliziumcarbid. Ebenso kann der Träger 4 mit einem Glas oder einer Keramik gestaltet sein. Es können dem Träger 4 zur Steigerung der Wärmeleitfähigkeit weitere Materialien beigegeben sein.

Beim Ausführungsbeispiel gemäß Figur 4 befindet sich die Lochblende 12 zwischen dem Konversionsmittel 3 und dem Träger 4. Das Material der Lochblende 12 kann zu einer Haftverbesserung zwischen dem Konversionsmittel 3 und dem Träger 4 dienen.

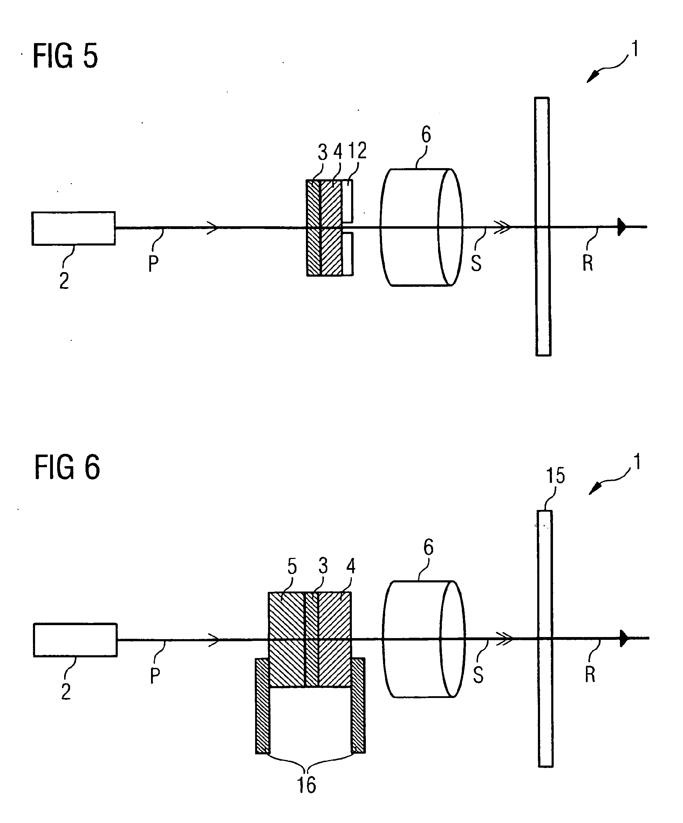

In Figur 5 ist dargestellt, dass sich die Lochblende 12 auf einer dem Konversionsmittel 3 abgewandten Hauptseite des Trägers 4 befindet. Der Träger 4 ist bezüglich der Wellenlänge der Sekundärstrahlung S transparent gestaltet und weist bevorzugt eine Dicke im Bereich zwischen einschließlich 25 $\mu$m und 500 $\mu$m auf.

In Figur 6 umfasst das Leuchtmittel 1 einen zweiten Träger 5. Das Konversionsmittel 3 befindet sich zwischen dem ersten Träger 4 und dem zweiten Träger 5 und steht jeweils in direktem Kontakt mit den Materialien der Träger 4, 5. Außerdem umfasst das Leuchtmittel 1 zwei Halter 16, die bevorzugt mit einem Metall gestaltet sind und eine Wärmeableitung aus den Trägern 4, 5 verbessern.

Der erste Träger 4 ist transparent, sowohl bezüglich der Primärstrahlung P als auch bezüglich der Sekundärstrahlung S. Der zweite Träger 5 ist transparent bezüglich der Primärstrahlung P und kann reflektierend für die Sekundärstrahlung S wirken. Über eine solche Ausgestaltung der Träger 4, 5 ist es möglich, dass die vom Leuchtmittel 1 emittierte Strahlung R aus einer Mischung aus Primärstrahlung P und Sekundärstrahlung S besteht.

Bei dem Konversionsmittel 3 kann es sich um eine über Siebdruck auf den Träger 4 aufgebrachte Phosphorschicht handeln. Der zweite Träger 5 ist dann beispielsweise auf das Konversionsmittel 3 aufgeklebt. Das Konversionsmittel 3 beinhaltet oder besteht beispielsweise aus einem kristallinen und/oder keramischen Material, in das Farbzentren statistisch verteilt eingebracht sind. Ist das Konversionsmittel aus einem kristallinen Stoff aufgebaut, so wird beispielsweise ein dünnes Plättchen, das das Konversionsmittel 3 darstellt, aus einem größeren Kristall herausgesägt. Dieses Plättchen des Konversionsmittels 3 kann dann über eine dünne Kleberschicht beispielsweise am ersten Träger 4 befestigt sein. Der Kleber weist hierbei bevorzugt eine hohe thermische Leitfähigkeit und Strahlungsbeständigkeit auf.

Alternativ ist es möglich, das Konversionsmittel 3 über ein Waferbonding-Verfahren an den Trägern 4, 5 anzubringen. Hierbei wird über den Hauptflächen des Konversionsmittels 3 eine dünne Siliziumdioxidschicht aufgebracht, ebenso wie auf Hauptseiten der Träger 4, 5. Über Druck und Wärme wird dann eine permanente Verbindung zwischen Konversionsmittel 3 und Trägern 4, 5 über die Siliziumdioxidschichten vermittelt. Die Siliziumdioxidschichten sind in Figur 6 nicht dargestellt.

Eine weitere Möglichkeit zum Verbinden von erstem Träger 4 und Konversionsmittel 3 ist die Synthese von keramischen, transparenten und konverterhaltigen Schichten, die das Konversionsmittel 3 umfassen. Hierbei werden die Ausgangsstoffe für die transparente Schicht beziehungsweise den ersten Träger 4, also zum Beispiel Aluminiumoxidpulver, als dicke Lage ausgebreitet. Auf diese Schicht wird dann mit einer geringen Dicke ein Ausgangsmaterial für das Konversionsmittel 3 aufgebracht. Über anschließendes Sintern kann dann eine einzige keramische Schicht entstehen, sodass in diesem Fall der erste Träger 4 und das Konversionsmittel 3 einstückig ausgeführt sein können.

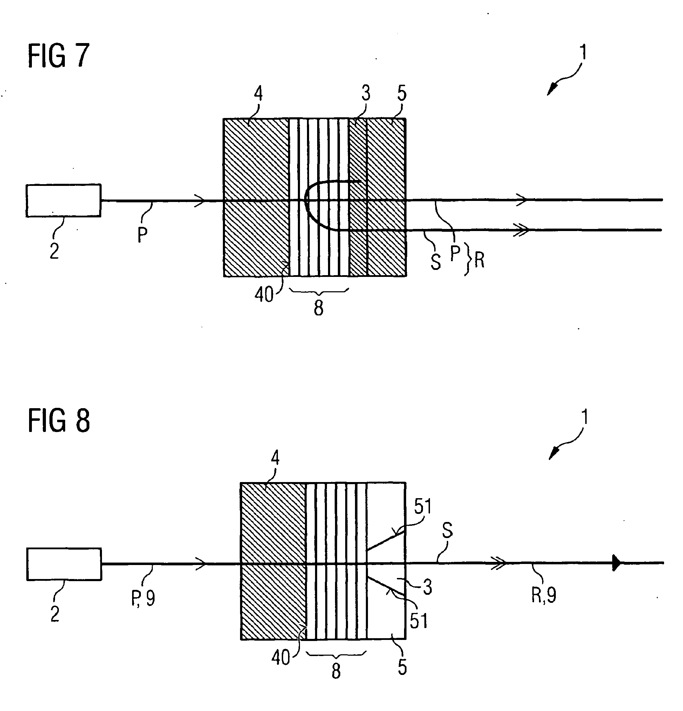

Beim Ausführungsbeispiel gemäß Figur 7 ist an der Hauptseite 40 des ersten Trägers 4 eine Beschichtung 8 aufgebracht, die einen Bragg-Spiegel darstellt. Die Beschichtung 8 ist transmittierend bezüglich der Primärstrahlung P und hoch reflektierend bezüglich der Sekundärstrahlung S. Die vom Leuchtmittel emittierte Strahlung R ist eine Mischung aus Primärstrahlung P und Sekundärstrahlung S. Zur besseren Wärmeabfuhr aus dem Konversionsmittel 3 befindet sich dieses erneut zwischen dem ersten Träger 4 und dem zweiten Träger 5.

Beim Ausführungsbeispiel gemäß Figur 8 weist der zweite Träger 5 eine kegelstumpfartige Ausnehmung auf, in der sich das Konversionsmittel 3 befindet. Flanken 51 des zweiten Trägers 5 sind reflektierend bezüglich der Sekundärstrahlung S gestaltet. Zum Beispiel ist der zweite Träger 5 massiv mit einem Metall gestaltet.

Anders als in Figur 8 dargestellt, können die Flanken 51 eine paraboloide Form aufweisen, sodass über Reflexion der Sekundärstrahlung S an den Flanken 51 ein paralleles Strahlbündel resultieren kann. Die Flanken 51 können rotationssymmetrisch bezüglich eines Strahlwegs 9 geformt sein. Der Strahlweg 9 ist definiert durch die Hauptstrahlrichtungen der Primärstrahlung P und der vom Leuchtmittel 1 emittierten Strahlung R.

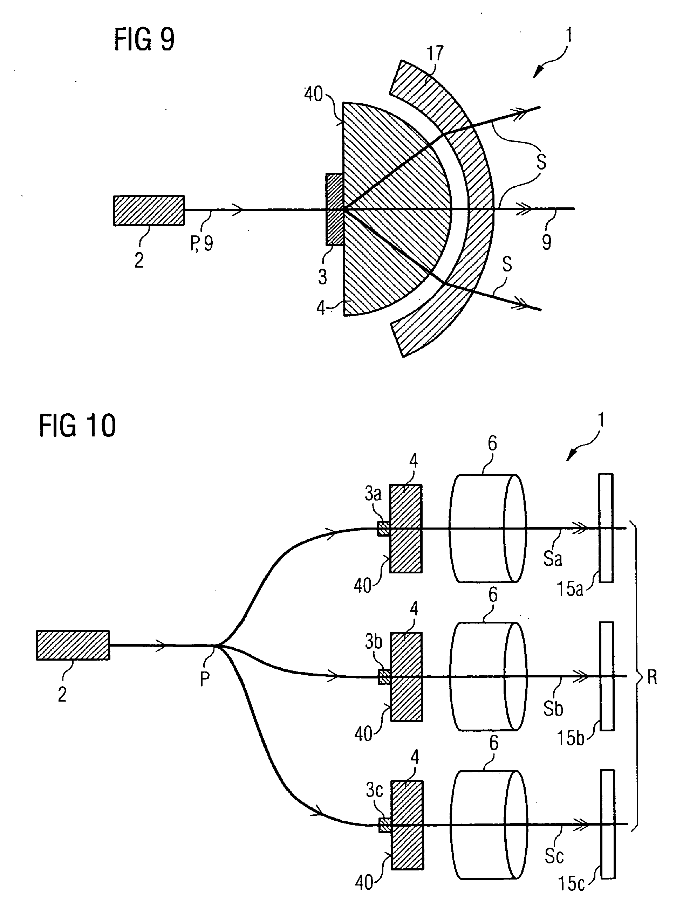

In Figur 9 ist ein Ausführungsbeispiel gezeigt, bei dem der erste Träger 4 linsenartig geformt ist. Hierdurch wird an einer dem Konversionsmittel 3 abgewandten, gekrümmten Außenfläche des ersten Trägers 4 die Sekundärstrahlung S in Richtung hin zu einer optischen Achse und in Richtung hin zum Strahlweg 9 abgelenkt. Zu einer zusätzlichen Kollimation umfasst das Leuchtmittel 1 eine als Konkav-Konvexlinse gestaltete Linse 17. Eine Lichtbrechung der Sekundärstrahlung S an den Grenzflächen der Linse 17 und des ersten Trägers 4 ist in Figur 9 lediglich schematisch gezeichnet.

Anders als in Figur 9 dargestellt, kann die dem Halbleiterlaser 2 zugewandte Hauptseite 40 des ersten Trägers 4 nicht flach sondern auch gekrümmt sein. Ebenso ist es möglich, dass sich das Konversionsmittel 3 in einer nicht dargestellten Ausnehmung im ersten Träger 4 befinden kann.

Beim Ausführungsbeispiel gemäß Figur 10 werden drei verschiedene Konversionsmittel 3a-c, die jeweils in einem kleinen Bereich auf den Trägern 4 aufgebracht sind, über Lichtleiter aus einem einzigen Halbleiterlaser 2 mit der Primärstrahlung P versorgt. Die Anordnung von Konversionsmitteln 3a-c, Trägern 4, Kollimatoroptiken 6 und Filtern 15a-c kann analog zum Ausführungsbeispiel etwa gemäß Figur 2 gestaltet sein.

Die Konversionsmittel 3a-c sind zur Erzeugung von rotem, grünem und blauem Licht gestaltet. Die Filter 15a-c sind dazu eingerichtet, jeweils einen vom jeweiligen Konversionsmittel 3a-c emittierten Spektralbereich der Sekundärstrahlung S zu transmittieren. Bezüglich der Primärstrahlung P sind die Filter 15a-c undurchlässig. Die vom Leuchtmittel 1 emittierte Strahlung R ist eine Mischung der Sekundärstrahlungen Sa-c.

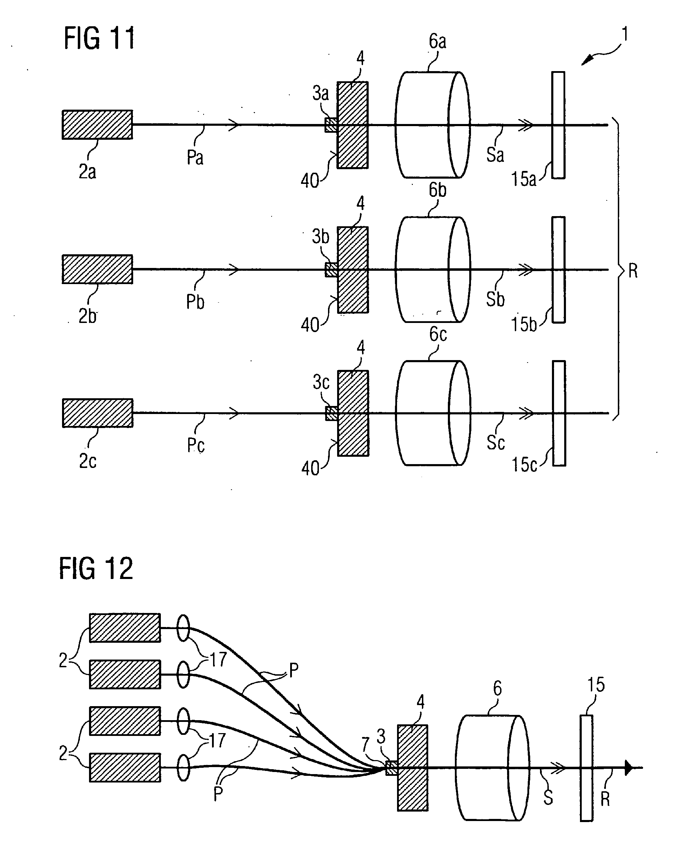

Beim Ausführungsbeispiel des Leuchtmittels 1 gemäß Figur 11 weist dieses drei Halbleiterlaser 2a-c auf, die drei verschiedene Primärstrahlungen Pa-c erzeugen. Über die drei verschiedenen Konversionsmittel 3a-c werden die drei Sekundärstrahlungen Sa-c erzeugt, die unterschiedliche Wellenlängen aufweisen. Die vom Leuchtmittel 1 emittierte Strahlung R ist eine Mischstrahlung aus diesen drei Sekundärstrahlungen Sa-c.

Es ist möglich, dass die Halbleiterlaser 2a-c bei leicht unterschiedlichen Wellenlängen emittieren, sodass die verschiedenen Konversionsmittel 3a-c effizient optisch gepumpt werden können. Alternativ kann es sich bei den Halbleiterlasern 2a-c um identische Halbleiterlaser handeln, sodass eine Ansteuerung beziehungsweise Bestromung der Halbleiterlaser 2a-c vereinfacht ist.

In Figur 12 ist ein Leuchtmittel 1 gezeigt, bei dem vier Halbleiterlaser 2 über Linsen 17 in eine Faseroptik gekoppelt werden und gemeinsam den Leuchtfleck 7 des Konversionsmittels 3 bestrahlen, um eine besonders hohe Leuchtdichte der Sekundärstrahlung S zu erzielen.

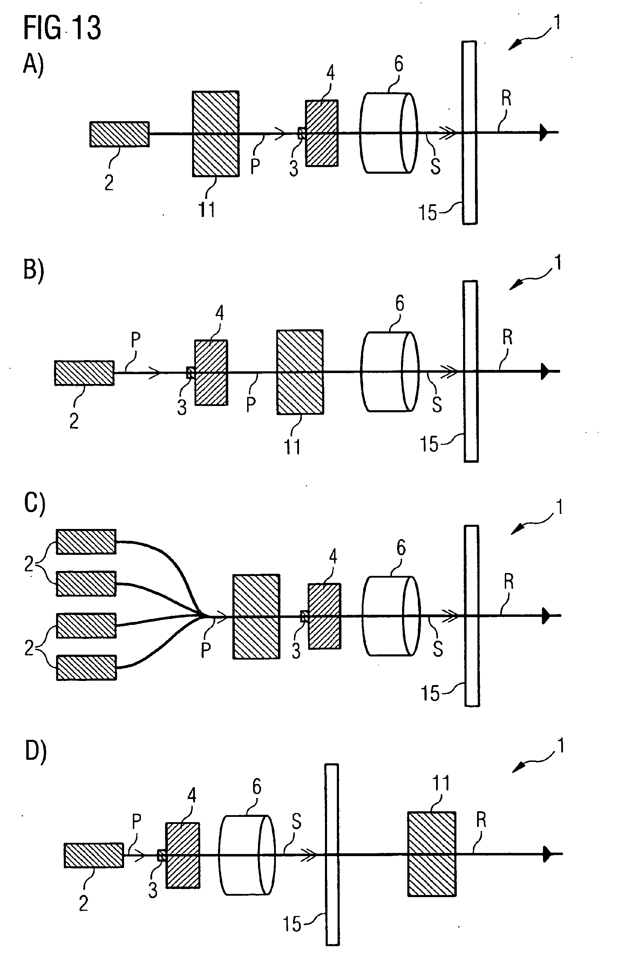

Gemäß Figur 13 weist das Leuchtmittel 1 einen Modulator 11 auf. Der Modulator 11 ist zum Beispiel durch eine Flüssigkristallmaske, einen Mikrospiegelaktor, eine Kerr-Zelle oder eine Pockels-Zelle gebildet. Über den Modulator 11 kann über Reflexion oder Transmission insbesondere die Intensität der Primärstrahlung P oder der Sekundärstrahlung S eingestellt werden. Bevorzugt kann der Modulator 11 mit Frequenzen von mindestens 10 MHz, insbesondere von mindestens 25 MHz abgestimmt beziehungsweise angesprochen werden.

Gemäß Figur 13A befindet sich der Modulator 11 zwischen dem Halbleiterlaser 2 und dem Konversionsmittel im Strahlengang der Primärstrahlung P. Gemäß Figur 13B ist der Modulator 11 zwischen der Kollimatoroptik 6 und dem Träger 4 im Strahlengang der Sekundärstrahlung S angebracht.

In Figur 13C ist gezeigt, dass der Modulator 11 in eine Faseroptik integriert ist, die dazu eingerichtet ist, die Pumpstrahlung P von vier Halbleiterlasern 2 zum Konversionsmittel 3 zu führen.

Auch kann sich, siehe Figur 13D, der Modulator 11 im Strahlengang nach dem Filter 15 befinden, sodass die Mischstrahlung aus der Primärstrahlung P und aus der Sekundärstrahlung S moduliert werden kann.

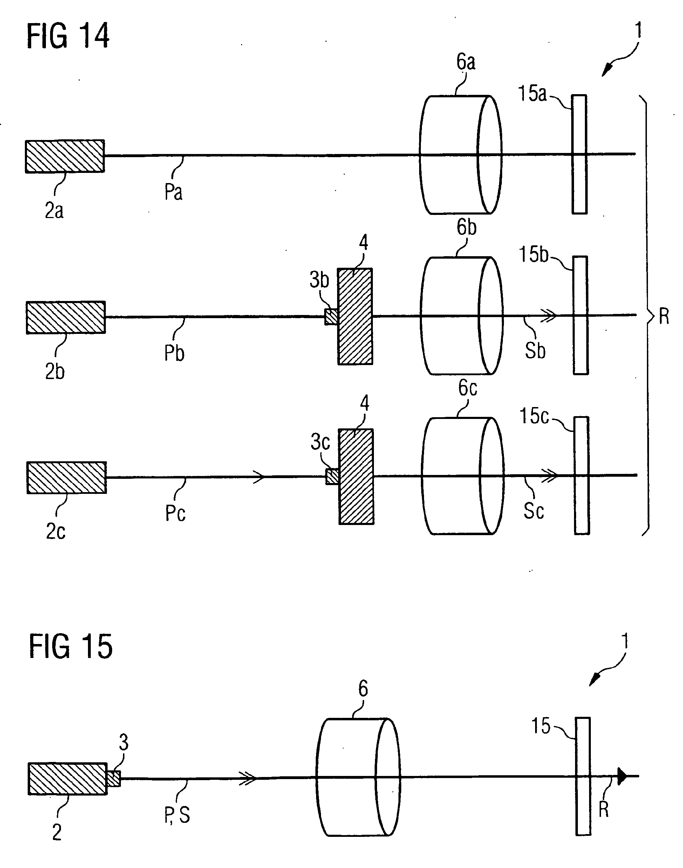

Beim Ausführungsbeispiel gemäß Figur 14 weist das Leuchtmittel 1 drei identische Halbleiterlaser 2a-c auf. Die Primärstrahlungen Pa-c weisen Wellenlängen im blauen Spektralbereich auf. Die Primärstrahlungen Pb, Pc werden von den Konversionsmitteln 3b, 3c in die grüne Sekundärstrahlung Sb und in die rote Sekundärstrahlung Sc konvertiert. Eine Konversion der Primärstrahlung Pa erfolgt nicht. Die vom Leuchtmittel 1 emittierte Strahlung R ist dann eine Mischung aus der Primärstrahlung Pa und den Sekundärstrahlungen Sb, Sc.

In Figur 15 ist ein Ausführungsbeispiel des Leuchtmittels 1 gezeigt, bei dem das Konversionsmittel 3 direkt auf dem Halbleiterlaser 2 aufgebracht ist. Dies kann insbesondere zur Folge haben, dass das Konversionsmittel 3 mit dem Halbleiterlaser 2 thermisch gekoppelt ist.

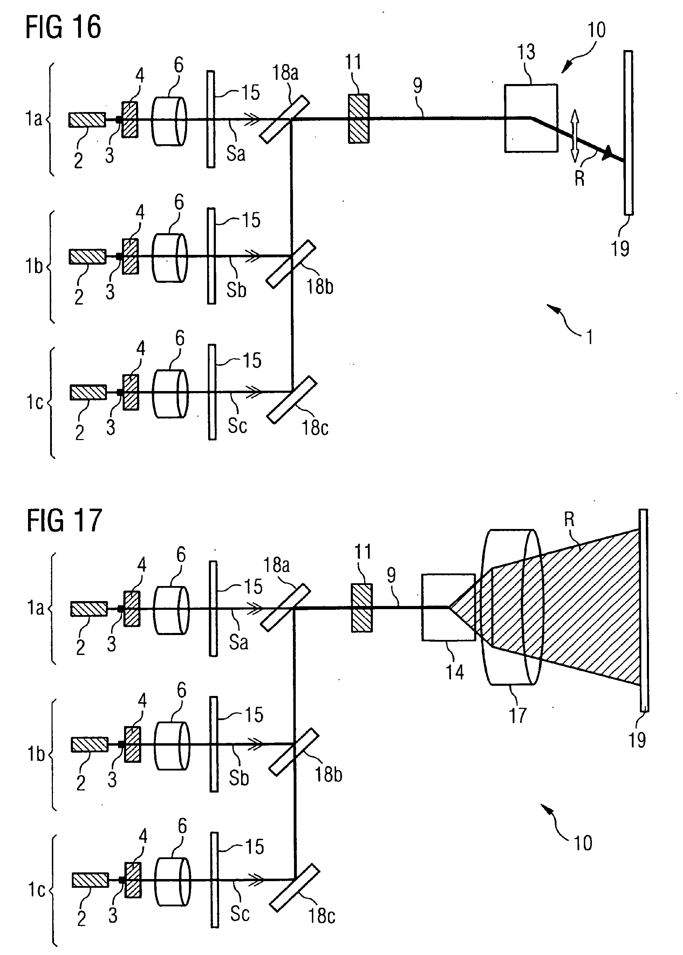

In Figur 16 ist ein Ausführungsbeispiel eines Projektors 10 gezeigt. Drei Leuchtmittel 1a-c emittieren die rote, grüne und blaue Sekundärstrahlung Sa-c. Über Spiegel 18a-c, die als dichroitische Spiegel ausgestaltet sein können und beispielsweise mehrere dielektrische Schichten umfassen, werden die Sekundärstrahlungen Sa-c auf den gemeinsamen Strahlweg 9 gelenkt. In dem gemeinsamen Strahlweg 9 befindet sich der Modulator 11, über den die Intensität der Sekundärstrahlungen Sa-c sowie der Farbort der vom Leuchtmittel 1 emittierten Strahlung R mit einer hohen Frequenz moduliert werden kann.

Dem Modulator 11 ist eine Ablenkeinheit 13 nachgeordnet, die mit einem Mikrospiegelaktor oder mit einem schnell beweglichen Spiegel gestaltet sein kann. Über die Ablenkeinheit 13 wird die Strahlung R, die ein näherungsweise paralleles Strahlbündel darstellt, abgelenkt und schnell über eine Projektionsfläche 19 geführt, auf der dann ein Bild erscheint. Bei dem Projektor 10 gemäß Figur 16 handelt es sich also insbesondere um einen so genannten Flying Spot Projector.

Alternativ zur Darstellung gemäß Figur 16 ist es ebenso möglich, dass sich drei unterschiedliche Modulatoren 11 jeweils beispielsweise in den Strahlgängen der Sekundärstrahlungen Sa-c befinden.

Der Projektor 10 gemäß Figur 17 verfügt über eine Abbildungseinheit 14, die dem Modulator 11 im gemeinsamen Strahlweg 9 nachgeordnet ist. Die Abbildungseinheit 14 kann eine Flüssigkristallmaske oder einen Digital Micro-Mirror Device, kurz DMD, aufweisen. Der Abbildungseinheit 14 ist eine Linse 17 nachgeordnet, die die vom Leuchtmittel 1 beziehungsweise vom Projektor 10 emittierte Strahlung R auf die Projektionsfläche 19 abbildet. Bei der Linse 17 kann es sich auch um ein Linsensystem handeln.

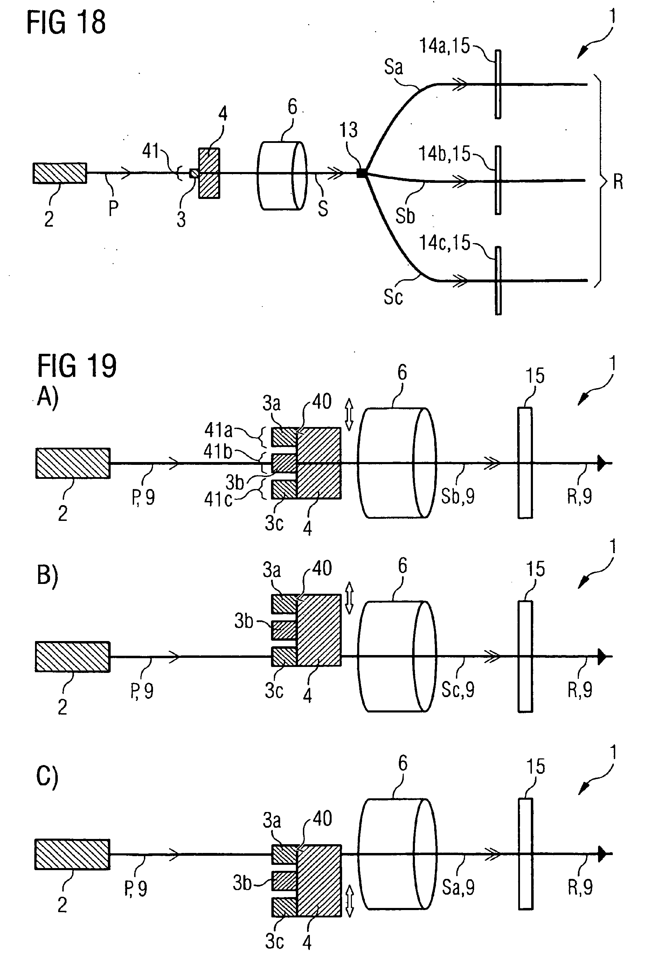

Das Leuchtmittel 1 gemäß Figur 18 weist ein einziges Konversionsmittel 3 auf, das in einem kleinen Bereich 41 des Trägers 4 aufgebracht ist. Dem Konversionsmittel 3 ist eine Kollimatoroptik 6 nachgeordnet. In Strahlrichtung nach der Kollimatoroptik 6 befindet sich die Ablenkeinheit 13. Bei der Ablenkeinheit 13 kann es sich um einen beweglichen Spiegel oder auch um eine Faseroptik handeln. Durch die Ablenkeinheit 13 ist die Sekundärstrahlung S in die Sekundärstrahlungen Sac aufgeteilt. Bei diesen Sekundärstrahlungen Sa-c kann es sich jeweils um weißes Licht oder auch um spektral aufgeteiltes rotes, grünes und blaues Licht handeln. Den Sekundärstrahlungen Sa-c sind optional jeweils Abbildungseinheiten 14a-c und/oder Filter 15 nachgeordnet. Die vom Leuchtmittel 1 emittierte Strahlung R setzt sich zusammen aus den Sekundärstrahlungen Sa-c, die die Filter 15 und/oder die Abbildungseinheiten 14a-c durchlaufen haben.

Beim Ausführungsbeispiel gemäß Figur 19 ist der Träger 4 beweglich gelagert. Mit anderen Worten kann der Träger 4, auf den die drei Bereiche 41a-c mit den insbesondere voneinander verschiedenen Konversionsmitteln 3a-c aufgebracht sind, in einer Richtung senkrecht zum Strahlweg 9 verschoben und positioniert werden. Die Konversionsmittel 3a-c können unterschiedliche Dicken, in einer Richtung senkrecht zur Hauptseite 40, aufweisen. Die Bewegungsrichtung des ersten Trägers 4 ist durch einen Doppelpfeil gekennzeichnet.

Durch Verschieben des ersten Trägers 4 in Richtung senkrecht zum Strahlweg 9 ist es möglich, dass in Abhängigkeit von der Position des ersten Trägers 4 unterschiedliche Bereiche 41a-c und somit unterschiedliche Konversionsmittel 3a-c von der Primärstrahlung P bestrahlt werden. Abhängig von der Position des ersten Trägers kann also der Farbort und/oder die Intensität der vom Leuchtmittel 1 emittierten Strahlung R festgelegt werden.

Gemäß Figur 19A wird beispielsweise grünes Licht erzeugt, gemäß Figur 19B zum Beispiel rotes Licht und gemäß Figur 19C zum Beispiel blaues Licht. Über den Filter 15, der optional nach der Kollimatoroptik 6 angebracht sein kann, kann der Farbort der vom Leuchtmittel 1 emittierten Strahlung R weiter eingeschränkt werden.

Das Leuchtmittel 1 gemäß Figur 19 kann zum Beispiel in einem Laserpointer eingesetzt werden, der, in Abhängigkeit von der Position des ersten Trägers, in unterschiedlichen Farben emittiert. In diesem Fall wird der erste Träger 4 beispielsweise in drei, jeweils über beispielsweise ein Einrasten des ersten Trägers 4 fixierbare Positionen gehalten. Während das Leuchtmittel 1 die Strahlung R emittiert, wird dann die Position des ersten Trägers 4 bevorzugt nicht verändert.

Ebenso ist es möglich, dass der erste Träger 4 sich vergleichsweise schnell bewegt, sodass die Konversionsmittel 3a-c in schneller Folge abwechselnd von der Primärstrahlung P bestrahlt werden. Dies vermindert beispielsweise eine thermische Belastung der Konversionsmittel 3a-c durch die Konversion der Primärstrahlung P. In dem Fall, dass der erste Träger 4 sich schnell bewegt, beispielsweise über ein Rotieren, kann das Leuchtmittel 1 etwa in einem Projektor eingesetzt werden. In diesem Falle befindet sich insbesondere zwischen dem Halbleiterlaser 2 und dem ersten Träger 4 mit den Konversionsmitteln 3a-c ein in Figur 19 nicht gezeichneter Modulator.

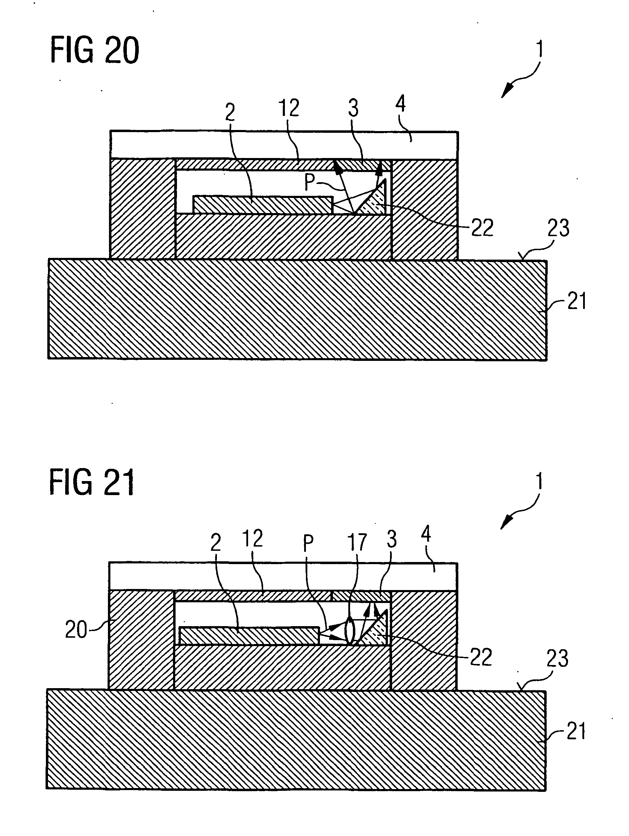

Beim Ausführungsbeispiel gemäß Figur 20 befindet sich der insbesondere genau eine Halbleiterlaser 2 vollständig in einem Gehäuse 20. Bei dem Gehäuse 20 kann es sich um ein oberflächenmontierbares Gehäuse, beispielsweise ein SMTlötbares Gehäuse, handeln. Das Gehäuse 20 kann auch als so genanntes Transistor Single Outline-Gehäuse, kurz TO-Gehäuse, gestaltet sein. Das Gehäuse 20 ist zum Beispiel über Löten oder ein elektrisch leitfähiges Kleben an einem nicht zum Leuchtmittel 1 gehörigen Körper 21 befestigt. Mit der Befestigung des Gehäuses 20 am Körper 21, der insbesondere als Kühlkörper oder Leiterplatte gestaltet sein kann, erfolgt bevorzugt auch eine elektrische Verschaltung des Leuchtmittels 1.

Der Halbleiterlaser 2 emittiert die Primärstrahlung P mit einem relativ großen Divergenzwinkel in einer Richtung parallel zu einer Hauptseite 23 des Körpers 21. Die Primärstrahlung P ist durch Pfeil-Linien symbolisiert. Die Primärstrahlung P wird nachfolgend über ein Prisma 22 in eine Richtung senkrecht zur Hauptseite 23 umgelenkt. Das Prisma 22 wirkt beispielsweise über Totalreflexion oder über eine nicht gezeichnete reflektierende Beschichtung an der dem Halbleiterlaser 2 zugewandten Seite.

Dem Prisma 22 in Strahlrichtung nachgeordnet befindet sich das Konversionsmittel 3, das auf dem ersten Träger 4 auf einer dem Halbleiterlaser 2 zugewandten Seite in einer Schicht aufgebracht ist. Der erste Träger 4 wirkt bevorzugt bezüglich der in Figur 20 nicht gezeichneten Sekundärstrahlung S transmittierend und bezüglich der Primärstrahlung P entweder transmittierend oder undurchlässig.

In Bereichen des ersten Trägers 4, in dem kein Konversionsmittel 3 aufgebracht ist, befindet sich das Material der Lochblende 12. Hierdurch ist gewährleistet, dass aus dem Leuchtmittel 1 nur in dem Bereich Strahlung austritt, in dem sich das Konversionsmittel 3 befindet.

Beim Ausführungsbeispiel gemäß Figur 21 ist zwischen dem Prisma 22 und dem Halbleiterlaser 2 die Linse 17 angebracht. Über die Linse 17 ist es möglich, die Primärstrahlung P in das Konversionsmittel 3 zu fokussieren.

Gemäß Figur 21 ist das Gehäuse 20 einstückig, beispielsweise durch einen Kunststoffgrundkörper, gebildet. Ebenso kann das Gehäuse 20 aus mehreren Teilen zusammengesetzt sein.

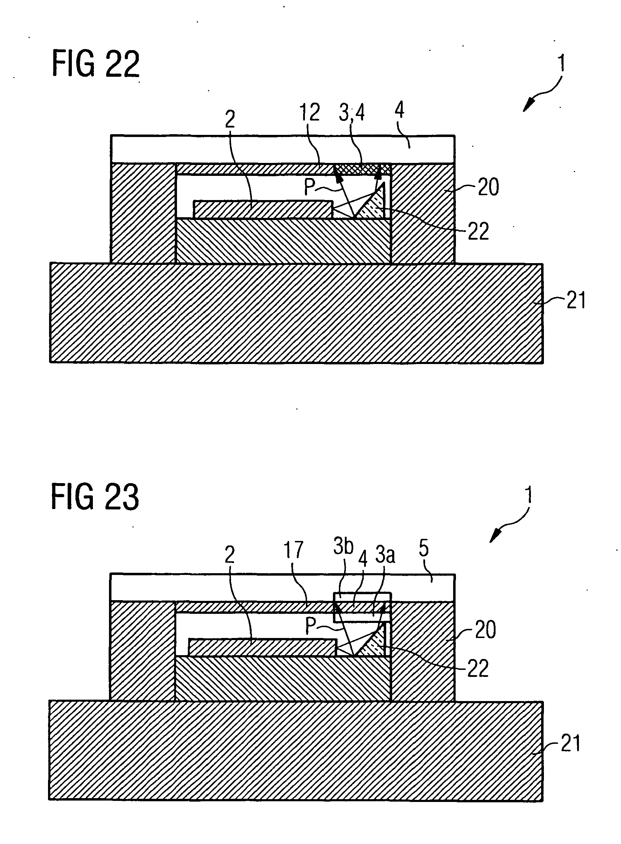

In Figur 22 ist gezeigt, dass das Konversionsmittel 3 in einem Matrixmaterial eingebettet sein kann. Das Matrixmaterial ist bevorzugt mit demselben Material wie der erste Träger 4 gebildet. Insbesondere können Konversionsmittel 3 und erster Träger 4 hierdurch einstückig ausgeführt sein. Beispielsweise können das Konversionsmittel 3 und das Material des ersten Trägers 4 über einen gemeinsamen Sinterprozess miteinander kombiniert beziehungsweise verbunden sein.

Wie in Figur 23 zu sehen ist, ist auf dem ersten Träger 4 beidseitig das Konversionsmittel 3a, b aufgebracht. Bei dem ersten Träger 4 kann es sich um eine dünne, transparente Keramikplatte handeln. Der erste Träger 4 mit den Konversionsmitteln 3a, b ist auf dem zweiten Träger 5 aufgebracht. Die Konversionsmittel 3a, b sowie der erste Träger 4 können optional vollständig oder zum Teil in einer Ausnehmung des zweiten Trägers 5 eingebracht sein. Die Konversionsmittel 3a, 3b können identische oder unterschiedliche Leuchtstoffe enthalten.

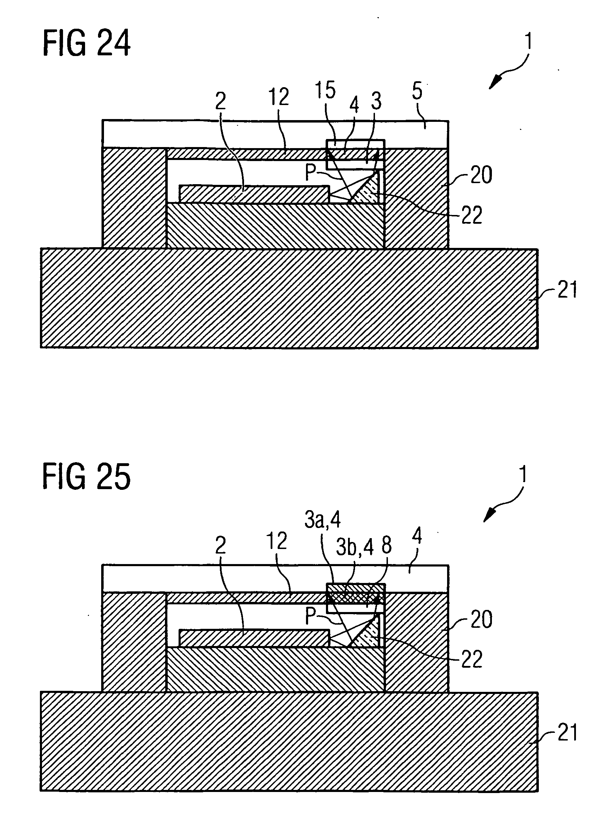

Beim Ausführungsbeispiel gemäß Figur 24, bei dem der erste Träger 4 ebenfalls beispielsweise ein Keramikplättchen ist, sind auf einer Seite des ersten Trägers 4 das Konversionsmittel 3 und auf der dem Konversionsmittel 3 und dem Halbleiterlaser 2 abgewandten Seite der Filter 15 schichtartig aufgebracht. Optional ist es möglich, dass der zweite Träger 5 eine Beimengung von Pigmenten, Partikeln oder Farbstoffen aufweist, sodass der zweite Träger 5 die Funktion des Filters 15 übernehmen kann.

Das Leuchtmittel 1 gemäß Figur 25 weist zwei verschiedene Konversionsmittel 3a, b auf. Die Konversionsmittel 3a, b sind in das Wärme leitende Matrixmaterial des ersten Trägers 4 eingebettet. Hierdurch erfolgt eine effiziente Wärmeleitung weg vom Konversionsmittel 3. Ebenso ist es möglich, dass, anders als in Figur 25 dargestellt, zum Beispiel das Konversionsmittel 3b in ein Matrixmaterial, aus dem der zweite Träger 5 gebildet ist, eingebettet ist.

Zwischen den Konversionsmitteln 3a, b und dem ersten Träger 4 einerseits und dem Prisma 22 andererseits befindet sich die Beschichtung 8. Die Beschichtung 8 wirkt transmittierend bezüglich der Primärstrahlung P und reflektierend bezüglich der in Figur 25 nicht eingezeichneten Sekundärstrahlung S, sodass eine Auskoppeleffizienz bezüglich der Sekundärstrahlung S aus dem Leuchtmittel 1 gesteigert ist.

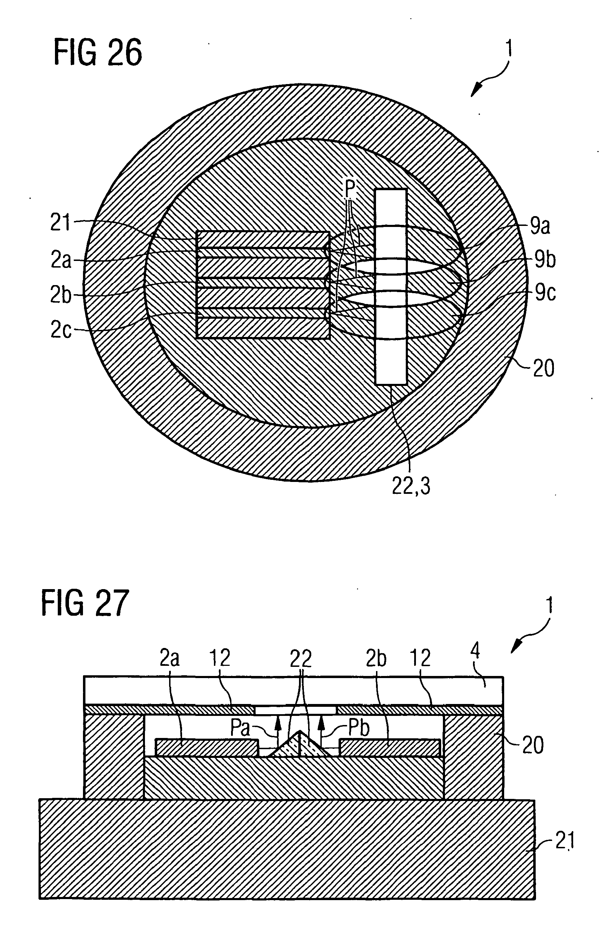

In Figur 26 ist eine Draufsicht auf das Leuchtmittel 1 etwa gemäß einer der Figuren 20 bis 25 illustriert. Das Gehäuse 20 weist einen kreisförmigen Grundriss auf. In einer kreisförmigen Ausnehmung befinden sich die drei Halbleiterlaser 2a-c, die die Primärstrahlung P emittieren. Über das Prisma 22 wird die Primärstrahlung P auf das Konversionsmittel 3 gelenkt und in die Sekundärstrahlungen Sa-c konvertiert, die das Leuchtmittel 1 in einer Richtung senkrecht zur Zeichenebene verlassen.

Die Halbleiterlaser 2a-c können identisch oder auch verschieden aufgebaut sein. Es ist möglich, dass die Halbleiterlaser 2a-c direkt auf dem Körper 21 aufgebracht und direkt an diesem elektrisch kontaktiert sind.

Im Leuchtmittel 1 gemäß Figur 27 sind die Halbleiterlaser 2a, 2b so angeordnet, dass sie die Primärstrahlungen Pa, b antiparallel emittieren. Eine Umlenkung der Primärstrahlungen Pa, b erfolgt über die zwei Prismen 22 in Richtung hin zum Konversionsmittel 3.

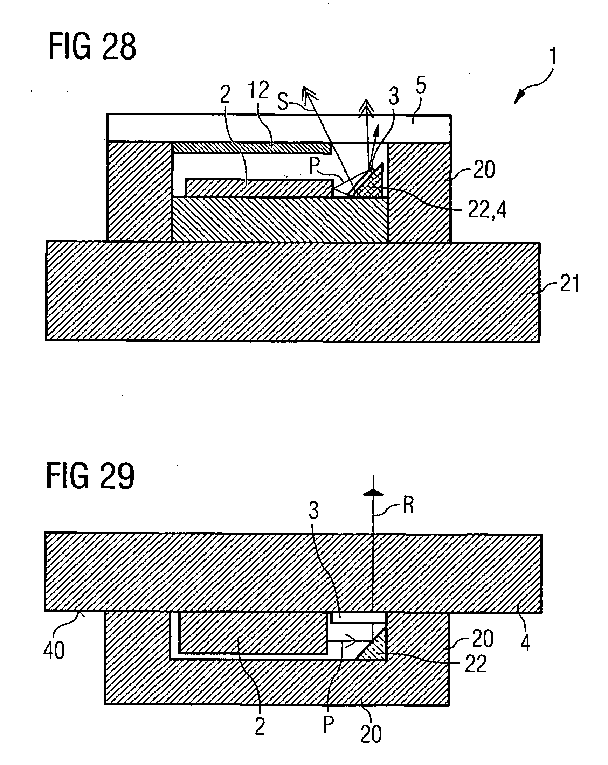

Beim Ausführungsbeispiel gemäß Figur 28 ist das Konversionsmittel 3 auf dem Prisma 22, das gleichzeitig den ersten Träger 4 bildet, aufgebracht. Die dem Halbleiterlaser 2 zugewandte Seite des Prismas 22, auf der das Konversionsmittel 3 aufgebracht ist, wirkt reflektierend sowohl bezüglich der Primärstrahlung P als auch bezüglich der Sekundärstrahlung S. Hierdurch kann die Schichtdicke des Konversionsmittels 3 reduziert werden, da die Primärstrahlung P aufgrund der Reflexion am Prisma 22 effektiv eine verdoppelte Schichtdicke des Konversionsmittel 3 wahrnimmt. Der zweite Träger 5 ist zum Beispiel undurchlässig bezüglich der Primärstrahlung P und transmittierend bezüglich der Sekundärstrahlung S ausgeführt. Bevorzugt ist der zweite Träger 5 transparent bezüglich der Sekundärstrahlung S und etwa mit antireflektierend wirkenden, in Figur 28 nicht gezeichneten Beschichtungen versehen.

Beim Ausführungsbeispiel gemäß Figur 29 ist sowohl der Halbleiterlaser 2 als auch das Konversionsmittel 3 direkt auf dem ersten Träger 4 aufgebracht. Die Primärstrahlung P wird über das am Gehäuse 20 angebrachte Prisma 22 in Richtung zum Konversionsmittel 3 und zum ersten Träger 4 hin umgelenkt. Die vom Leuchtmittel 1 emittierte Strahlung R durchläuft den transparenten, thermisch leitfähigen ersten Träger 4. Auf der Hauptseite 40 des ersten Trägers 4 sind beispielsweise elektrische Leiterbahnen zur Stromversorgung des Halbleiterlasers 2 aufgebracht. Optional kann eine in Figur 29 nicht gezeichnete Lochblende am Träger 4 angebracht sein.

**Patentansprüche**

1. Leuchtmittel (1) mit

   - mindestens einem Halbleiterlaser (2), der dazu eingerichtet ist, eine Primärstrahlung (P) mit einer Wellenlänge zwischen einschließlich 360 nm und 485 nm zu emittieren, und
   - mindestens einem Konversionsmittel (3), das dem Halbleiterlaser (2) nachgeordnet und dazu eingerichtet ist, wenigstens einen Teil der Primärstrahlung (P) in eine Sekundärstrahlung (S) mit einer von der Primärstrahlung (P) verschiedenen, größeren Wellenlänge zu konvertieren,

   **dadurch gekennzeichnet, dass**
   die vom Leuchtmittel (1) emittierte Strahlung (R) eine optische Kohärenzlänge aufweist, die höchstens 50 $\mu$m beträgt, wobei das Konversionsmittel (3) eine Konzentration von Farbzentren oder Leuchtpunkten aufweist, die mindestens $10^7/\mu m^3$ beträgt und die Farbzentren oder Leuchtpunkte statistisch im Konversionsmittel verteilt sind, und wobei ein von der Primärstrahlung (P) bestrahlter Leuchtfleck (7) des Konversionsmittels (3) eine Fläche von höchstens 0,5 $mm^2$ aufweist.

2. Leuchtmittel (1) nach Anspruch 1,
   bei dem eine Leuchtdichte der Sekundärstrahlung (S) beim Austritt aus dem Konversionsmittel (3) wenigstens stellenweise mindestens 1 $kW/cm^2$ beträgt.

3. Leuchtmittel (1) nach Anspruch 1 oder 2,
   das einen thermisch leitfähigen, ersten Träger (4) umfasst, an dem das Konversionsmittel (3) zumindest mittelbar angebracht ist und der für mindestens einen Teil der Sekundärstrahlung (S) transparent ist oder reflektierend wirkt, und der für die Primärstrahlung (P) transparent oder undurchlässig ist.

4. Leuchtmittel (1) nach einem der vorhergehenden Ansprüche,
   das zumindest eine Kollimatoroptik (6) umfasst, die dem Konversionsmittel (3) nachgeordnet ist, wobei ein Divergenzwinkel der Sekundärstrahlung (S) nach Durchgang durch die Kollimatoroptik (6) zumindest stellenweise höchstens 10° beträgt.

**5.** Leuchtmittel (1) nach einem der vorhergehenden Ansprüche,
bei dem keine feste, regelmäßige oder gitterähnliche räumliche Beziehung zwischen einander benachbarten Farbzentren oder Leuchtpunkten besteht,
wobei die Farbzentren oder Leuchtpunkte die Sekundärstrahlung unabhängig voneinander emittieren, wobei die Fläche des Leuchtflecks (7) zwischen einschließlich 10 $\mu m^2$ und 10000 $\mu m^2$ beträgt.

**6.** Leuchtmittel (1) nach einem der vorhergehenden Ansprüche,
bei dem zumindest zwei Halbleiterlaser (2) denselben Leuchtfleck (7) bestrahlen.

**7.** Leuchtmittel (1) nach einem der vorhergehenden Ansprüche,
bei dem sich das Konversionsmittel (3) zwischen dem ersten Träger (4) und einem zweiten Träger (5) befindet und jeweils in mindestens mittelbarem Kontakt zu den Trägern (4, 5) steht, wobei die Primärstrahlung (P) zumindest einen der Träger (4, 5) durchläuft.

**8.** Leuchtmittel (1) nach einem der vorhergehenden Ansprüche,
bei dem eine Hauptseite (40) des ersten Trägers (4), auf der das Konversionsmittel (3) aufgebracht ist, zumindest bezüglich der Sekundärstrahlung (S) reflektierend wirkt oder mit einer reflektierenden Beschichtung (8) versehen ist, und bei dem durch den ersten Träger (4) ein Strahlweg (9) in seiner Richtung geändert ist.

**9.** Leuchtmittel (1) nach einem der vorhergehenden Ansprüche,
das wenigstens drei Halbleiterlaser (2) umfasst, wobei zumindest zwei der Halbleiterlaser (2) wenigstens zwei verschiedene Leuchtflecke (7) des mindestens einen Konversionsmittels (3) bestrahlen, und wobei die vom Leuchtmittel emittierte Strahlung (R) rotes, grünes und blaues Licht umfasst.

**10.** Leuchtmittel (1) nach dem vorhergehenden Anspruch, bei dem das rote, grüne und blaue Licht unabhängig voneinander erzeugbar sind und wenigstens einen Teil des Strahlwegs (9) gemeinsam durchlaufen.

**11.** Leuchtmittel (1) nach einem der vorhergehenden Ansprüche,
das wenigstens einen Modulator (11) umfasst, der sich im Strahlweg (9) der Sekundärstrahlung (S) befindet, und der dazu eingerichtet ist, über Transmission oder Reflexion eine Intensität der Sekundärstrahlung (S) einzustellen.

**12.** Leuchtmitteln (1) nach einem der vorhergehenden Ansprüche,
bei dem eine Intensität und/oder ein Farbort der vom Leuchtmittel (1) emittierten Strahlung (R) mit einer Frequenz von mindestens 10 MHz abstimmbar ist.

**13.** Leuchtmitteln (1) nach einem der vorhergehenden Ansprüche,
bei dem der erste Träger (4) mechanisch beweglich gelagert ist und wenigstens zwei Bereiche (41) aufweist, die mit voneinander verschiedenen Konversionsmitteln (3) versehen sind, so dass durch ein Bewegen des ersten Trägers (4) ein Farbort der Sekundärstrahlung (S) festlegbar ist.

**14.** Leuchtmitteln (1) nach einem der vorhergehenden Ansprüche,
bei dem

- der erste Träger (4) eine Wärmeleitfähigkeit von mindestens 40 W/(m K) aufweist,
- wenigstens eine Lochblende (12) dem Konversionsmittel (3) nachgeordnet ist oder das Konversionsmittel (3) an einem Bereich (41) des ersten Trägers (4) angebracht ist, der einen Durchmesser (D) aufweist, der höchstens einem Dreifachen eines mittleren Durchmessers (d) des Leuchtflecks (7) entspricht, und
- eine Ablenkeinheit (13) und/oder eine Abbildungseinheit (14) sich in oder an dem Strahlweg (9) befindet.

**15.** Projektor (10) mit mindestens einem Leuchtmittel (1) gemäß einem der vorhergehenden Ansprüche und mit mindestens einer Ablenkeinheit (13) und/oder mindestens einer Abbildungseinheit (14).

**Claims**

**1.** A light source (1) comprising:

- at least one semiconductor laser (2), which is designed to emit primary radiation (P) of a wavelength of between 360 nm and 485 nm inclusively, and
- at least one conversion medium (3), which is arranged downstream of the semiconductor laser (2) and is designed to convert at least part of the primary radiation (P) into secondary radiation (S) of a different, greater wavelength than the primary radiation (P),

**characterized in that**
the radiation (R) emitted by the light source (1) has an optical coherence length which amounts to at most 50 $\mu$m, wherein the conversion medium (3) has a concentration of colour centres or pixels which amounts to at least $10^7/\mu m^3$ and the colour centres or pixels are distributed statistically in the conversion medium, and wherein a light spot (7) of the conversion medium (3) which is irradiated by the primary radiation (P) has an area of at most 0.5 mm$^2$.

2.  A light source (1) according to claim 1,
    wherein a luminance of the secondary radiation (S) on exit from the conversion medium (3) amounts at least in places to at least 1 kW/cm$^2$.

3.  A light source (1) according to any of claims 1 or 2, comprising a thermally conductive first carrier (4), on which the conversion medium (3) is mounted at least indirectly and which is transparent or reflective for at least part of the secondary radiation (S), and which is transparent or impermeable for the primary radiation (P).

4.  A light source (1) according to any of the preceding claims,
    comprising at least one collimating optical system (6), which is arranged downstream of the conversion medium (3), wherein a divergence angle of the secondary radiation (S) amounts, after passage through the collimating optical system (6), at least in places to at most 10°.

5.  A light source (1) according to any of the preceding claims,
    wherein there is no fixed, regular or lattice-like spatial relationship between mutually adjacent colour centres or pixels, wherein the colour centres or pixels emit the secondary radiation mutually independently, the area of the light spot (7) lying in the range between 10 $\mu$m$^2$ and 10000 $\mu$m$^2$.

6.  A light source (1) according to any of the preceding claims,
    wherein at least two semiconductor lasers (2) irradiate the same light spot (7).

7.  A light source (1) according to any of the preceding claims,
    wherein the conversion medium (3) is located between the first carrier (4) and a second carrier (5) and is in each case in at least indirect contact with the carriers (4, 5), the primary radiation (P) passing through at least one of the carriers (4, 5).

8.  A light source (1) according to any of the preceding claims,
    wherein a major side (40) of the first carrier (4), to which the conversion medium (3) is applied, is reflective at least relative to the secondary radiation (S) or is provided with a reflective coating (8), and wherein the direction of a beam path (9) is modified by the first carrier (4).

9.  A light source (1) according to any of the preceding claims,
    comprising at least three semiconductor lasers (2), at least two of the semiconductor lasers (2) irradiating at least two different light spots (7) of the at least one conversion medium (3), and the radiation (R) emitted by the light source comprising red, green and blue light.

10. A light source (1) according to the preceding claim,
    wherein the red, green and blue light can be generated mutually independently and pass jointly along at least part of the beam path (9).

11. A light source (1) according to any of the preceding claims,
    comprising at least one modulator (11), which is located in the beam path (9) of the secondary radiation (S) and which is designed to adjust an intensity of the secondary radiation (S) by way of transmission or reflection.

12. A light source (1) according to any of the preceding claims,
    wherein an intensity and/or a chromaticity coordinate of the radiation (R) emitted by the light source (1) can be tuned to a frequency of at least 10 MHz.

**13.** A light source (1) according to any of the preceding claims,
wherein the first carrier (4) is mounted so as to be mechanically mobile and comprises at least two regions (41) which are provided with mutually different conversion media (3), such that a chromaticity coordinate of the secondary radiation (S) can be set by moving the first carrier (4).

**14.** A light source (1) according to any of the preceding claims,
wherein

- the first carrier (4) displays a thermal conductivity of at least 40 W/(m K),
- at least one pinhole (12) is arranged downstream of the conversion medium (3) or the conversion medium (3) is mounted on a region (41) of the first carrier (4) which has a diameter (D) which corresponds to at most three times an average diameter (d) of the light spot (7), and
- a deflection unit (13) and/or an imaging unit (14) is located in or on the beam path (9).

**15.** A projector (10) comprising at least one light source (1) according to any of the preceding claims and further comprising at least one deflection unit (13) and/or at least one imaging unit (14).

**Revendications**

**1.** Lampe (1) comprenant

- au moins un laser à semi-conducteur (2) qui est agencé pour émettre un rayonnement primaire (P) avec une longueur d'onde comprise entre 360 nm et 485 nm, et
- au moins un moyen de conversion (3) qui est disposé en aval du laser à semi-conducteur (2) et est agencé pour convertir au moins une partie du rayonnement primaire (P) en un rayonnement secondaire (S) avec une longueur d'onde plus grande, différente du rayonnement primaire (P),

**caractérisé en ce que**
le rayonnement (R) émis par la lampe (1) présente une longueur de cohérence optique qui est de maximum 50 $\mu$m, le moyen de conversion (3) présentant une concentration de centres de couleur ou de points lumineux qui est d'au moins $10^7/\mu m^3$ et les centres de couleur étant répartis statistiquement dans le moyen de conversion, et une tache lumineuse (7) du moyen de conversion (3) irradiée par le rayonnement primaire (P) présentant une surface de maximum 0,5 mm$^2$.

**2.** Lampe (1) selon la revendication 1,
dans laquelle une luminance du rayonnement secondaire (S) est au moins par endroits d'au moins 1 kW/cm$^2$ à la sortie du moyen de conversion (3).

**3.** Lampe (1) selon la revendication 1 ou 2,
qui comprend un premier support (4) thermiquement conducteur, sur lequel le moyen de conversion (3) est disposé du moins indirectement et qui est transparent ou agit de manière réfléchissante pour au moins une partie du rayonnement secondaire (S), et qui est transparent ou imperméable pour le rayonnement primaire (P).

**4.** Lampe (1) selon l'une quelconque des revendications précédentes,
qui comprend au moins une optique de collimation (6) qui est disposée en aval du moyen de conversion (3), un angle de divergence du rayonnement secondaire (S) étant au moins par endroits de maximum 10° après le passage à travers l'optique de collimation (6).

**5.** Lampe (1) selon l'une quelconque des revendications précédentes,
dans laquelle il n'y a pas de relation fixe, régulière ou similaire à un réseau entre des centres de couleur ou des points lumineux,
les centres de couleur ou les points lumineux émettant le rayonnement secondaire indépendamment les uns des autres, la surface de la tache lumineuse (7) étant comprise entre 10 $\mu$m$^2$ et 10000 $\mu$m$^2$.

**6.** Lampe (1) selon l'une quelconque des revendications précédentes,
dans laquelle au moins deux lasers à semi-conducteur (2) irradient la même tache lumineuse (7).

**7.** Lampe (1) selon l'une quelconque des revendications précédentes,
dans laquelle le moyen de conversion (3) se trouve entre le premier support (4) et un deuxième support (5) et est respectivement en contact au moins indirect avec les supports (4, 5), le rayonnement primaire (P) traversant au moins un des supports (4, 5).

**8.** Lampe (1) selon l'une quelconque des revendications précédentes,
dans laquelle un côté principal (40) du premier support (4), sur lequel est disposé le moyen de conversion (3), agit de manière réfléchissante ou est muni d'un revêtement réfléchissant (8) au moins par rapport au rayonnement secondaire (S), et dans laquelle une trajectoire de faisceau (9) à travers le premier support (4) est modifiée dans sa direction.

**9.** Lampe (1) selon l'une quelconque des revendications précédentes,
qui comprend au moins trois lasers à semi-conducteur (2), au moins deux des lasers à semi-conducteur (2) irradiant au moins deux taches lumineuses différentes (7) de l'au moins un moyen de conversion (3), et le rayonnement (R) émis par la lampe comprenant de la lumière rouge, de la lumière verte et de la lumière bleue.

**10.** Lampe (1) selon la revendication précédente,
dans laquelle la lumière rouge, la lumière verte et la lumière bleue peuvent être générées indépendamment l'une de l'autre et traversent en commun au moins une partie de la trajectoire du faisceau (9).

**11.** Lampe (1) selon l'une quelconque des revendications précédentes,
qui comprend au moins un modulateur (11) qui se trouve dans la trajectoire du faisceau (9) du rayonnement secondaire (S) et qui est agencé pour régler une intensité du rayonnement secondaire (S) par transmission ou réflexion.

**12.** Lampe (1) selon l'une quelconque des revendications précédentes,
dans laquelle une intensité et/ou un lieu de la couleur du rayonnement (R) émis par la lampe (1) peuvent être accordés avec une fréquence d'au moins 10 MHz.

**13.** Lampe (1) selon l'une quelconque des revendications précédentes,
dans laquelle le premier support (4) est logé de manière déplaçable mécaniquement et présente au moins deux zones (41) qui sont munies de moyens de conversion (3) différents les uns des autres de sorte qu'en raison d'un déplacement du premier support (4) un lieu de la couleur du rayonnement secondaire (S) peut être déterminé.

**14.** Lampe (1) selon l'une quelconque des revendications précédentes,
dans laquelle

- le premier support (4) présente une conductibilité thermique d'au moins 40 W/(m K),
- au moins un diaphragme à trou (12) est disposé en aval du moyen de conversion (3) ou (dans laquelle) le moyen de conversion (3) est disposé sur une zone (41) du premier support (4), laquelle présente un diamètre (D) qui correspond au maximum au triple d'un diamètre moyen (d) de la tache lumineuse (7), et
- une unité de déviation (13) et/ou une unité de reproduction (14) se trouvent dans ou sur la trajectoire du faisceau (9).

**15.** Projecteur (10) comprenant au moins une lampe (1) selon une quelconque des revendications précédentes et comprenant au moins une unité de déviation (13) et/ou au moins une unité de reproduction (14).

FIG 1

FIG 2

FIG 3

FIG 4

FIG 5

FIG 6

FIG 7

FIG 8

FIG 9

FIG 10

## FIG 11

## FIG 12

# FIG 13

A)

B)

C)

D)

## FIG 14

## FIG 15

FIG 16

FIG 17

FIG 18

FIG 19

A)

B)

C)

FIG 20

FIG 21

FIG 22

FIG 23

FIG 24

FIG 25

FIG 26

FIG 27

**FIG 28**

**FIG 29**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2006139926 A1
- WO 2006129211 A2
- US 20050265411 A1
- US 20070091945 A1
- US 20080116551 A1